# EUROPEAN PATENT APPLICATION

(11) **EP 4 819 810 A1**
(43) Date of publication of application: **07.10.2026**
(21) Application number: 24949324.8
(22) Date of filing: 10.09.2024
(51) Int. Cl.: H10K 59/126

(54) **DISPLAY PANEL AND DISPLAY APPARATUS**

(30) Priority: 31.07.2024 CN 202411046463
(71) Applicant: Wuhan Tianma Microelectronics Co., Ltd., Wuhan, Hubei 430205 (CN)
(72) Inventor: ZHANG, Dian, Wuhan, Hubei 430205 (CN)
(74) Representative: Völkl Siebenson Patentanwälte - Partnerschaft mbB
(86) International application number: PCT/CN2024/117866
(87) International publication number: WO 2026/025600

(57) **Abstract**

The embodiments of the present invention relate to the field of display and improve the circuit performance of pixel circuits. Provided are a display panel and a display apparatus. The display panel comprises: pixel circuits, each of which comprises a drive transistor and a first transistor, wherein an active layer of each first transistor comprises a metal oxide semiconductor material; circuit columns; a plurality of first circuit groups, wherein each first circuit group comprises two circuit columns, and in each first circuit group, the first transistors in two pixel circuits, which are adjacent in a first direction, are adjacent; data lines, which comprise first data lines and second data lines; and power signal lines, wherein with regard to the first data line, second data line and power signal line connected to a single circuit column, the first data line and the second data line are both located on the side of the drive transistor that is away from the first transistor in the circuit column, the power signal line is located on the side of the first data line and second data line that is close to the first transistor in the circuit column, and the power signal line overlaps with a connection line between the drive transistor and the first transistor, and the first transistor.

## Description

The present application claims priority to Chinese Patent Application filed with the State Intellectual Property Office on July 31, 2024, with Chinese Application No. 202411046463.1 and title "DISPLAY PANEL AND DISPLAY APPARATUS", the content of which is incorporated herein by reference in its entirety.

### TECHNICAL FIELD

The present disclosure relates to the technical field of displaying and, in particular, to a display panel and a display apparatus.

### BACKGROUND

The display panel includes a pixel circuit and a light-emitting element. The pixel circuit is configured to provide a driving current to the light-emitting element to drive the light-emitting element to emit light.

The pixel circuit includes a driving transistor and multiple switching transistors. In order to improve the current leakage problem of the driving transistor, some of the switching transistors are currently configured as metal oxide transistors. However, the active layer of such transistors is prone to generating free electrons due to the influence of light irradiation, resulting in a negative bias of the threshold voltage, thereby affecting the performance of the pixel circuit.

### SUMMARY

In view of the above, embodiments of the present disclosure provide a display panel and a display apparatus to improve the circuit performance of the pixel circuit.

In one aspect, an embodiment of the present disclosure provides a display panel, including: substrate; a pixel circuit including a driving transistor and at least one first transistor, a plurality of circuit columns arranged along a first direction; a plurality of first circuit groups arranged along the first direction; data lines including a first data line and a second data line; and power supply signal lines electrically connected to the circuit columns. An active layer of the first transistor includes a metal oxide semiconductor material, and a gate of the driving transistor is electrically connected to the first transistor through a connection line. Each circuit column of the plurality of circuit columns includes a plurality of the pixel circuits arranged along a second direction, and the first direction intersects the second direction. Each first circuit group of the plurality of first circuit groups includes two adjacent circuit columns, and in the first circuit group, the first transistors in two adjacent pixel circuits in the first direction are arranged adjacent to each other. One of the first data line and the second data line is electrically connected to an odd-numbered pixel circuit of the pixel circuits in the circuit column, and the other one of the first data line and the second data line is electrically connected to an even-numbered pixel circuit of the pixel circuits in the circuit column. With respect to the first data line, the second data line and the power supply signal line connected to a single circuit column, the first data line and the second data line are disposed on a side of the driving transistor in the circuit column away from the first transistor, the power supply signal line is disposed on a side of the first data line and the second data line that is adjacent to the first transistor in the circuit column, and in a direction perpendicular to the plane of the substrate, the power supply signal line overlaps the connection line and the active layer of the first transistor, respectively.

In another aspect, an embodiment of the present disclosure provides a display apparatus including the above display panel.

One of the above technical solutions has the following advantages. An embodiment of the present disclosure proposes a technical solution for a dual-data line panel structure with a large number of signal lines. By designing the arrangement of the pixel circuits and the arrangement of the data lines in a matched manner, the routing design of the power supply signal lines can be optimized, thereby enabling the electrical signal lines to shield the metal oxide transistors (first transistors) in the pixel circuits and the connection lines between the metal oxide transistors and the driving transistors.

Specifically, first, in the embodiment of the present disclosure, the arrangement of the pixel circuits in the two circuit columns in the first circuit group is adjusted. The first transistors in the adjacent pixel circuits in two circuit columns are arranged adjacent to each other, and thus the first transistors in the two adjacent pixel circuits can be arranged more concentrated and closer to the spacing area between the two circuit columns. Correspondingly, the distribution of the connection lines in the two pixel circuits is also relatively concentrated. Second, in the embodiment of the present disclosure, the first data line and the second data line that are connected to the single circuit column are disposed on the side of the driving transistor in the circuit column away from the first transistor. In this way, with respect to a single first circuit group, the data lines corresponding to the two circuit columns are respectively distributed on opposite sides of the two circuit columns and are relatively far apart, thereby freeing up routing space for the power supply signal lines in the middle position, so that two power supply signal lines corresponding to two circuit columns are both disposed between the data lines distributed on opposite sides. Furthermore, the power supply signal line can better cover the first transistor and the connection line.

The power supply signal line covers the first transistor, which can reduce the risk of light irradiating the active layer of the first transistor and improve the device stability of the first transistor. The power supply signal line covers the connection line, which can utilize the stable power supply voltage on the power supply signal line to stabilize the gate potential of the driving transistor, thereby improving the stability of the voltage of the first node.

In summary, in the embodiments of the present disclosure, by designing the arrangement of the pixel circuits and the arrangement of the data lines in a matched manner, a larger routing space can be freed up for the power supply signal line in the dual-data line panel structure with complex routing, thereby providing more convenient conditions for the power supply signal line to shield the first transistor and the connection line, so that the power supply signal line can better shield the first transistor and the connection line to optimize the circuit performance of the pixel circuit.

### BRIEF DESCRIPTION OF DRAWINGS

FIG. 1 is a schematic structural diagram of a display panel according to an embodiment of the present disclosure;
FIG. 2 is a schematic structural diagram of a pixel circuit according to an embodiment of the present disclosure;
FIG. 3 is a schematic diagram of a film layer structure of a display panel according to an embodiment of the present disclosure;
FIG. 4 is a schematic diagram of a further film layer structure of a display panel according to an embodiment of the present disclosure;
FIG. 5 is a schematic diagram of a further film layer structure of a display panel according to an embodiment of the present disclosure;
FIG. 6 is a schematic diagram of a data line, a power supply signal line, and a light-emitting element according to an embodiment of the present disclosure;
FIG. 7 is a schematic structural diagram of a further display panel according to an embodiment of the present disclosure;
FIG. 8 is a schematic diagram of a further film layer structure of a display panel according to an embodiment of the present disclosure;
FIG. 9 is a schematic cross-sectional view of a display panel according to an embodiment of the present disclosure;
FIG. 10 is a schematic structural diagram of a further display panel according to an embodiment of the present disclosure;
FIG. 11 is a schematic structural diagram of a further display panel according to an embodiment of the present disclosure;
FIG. 12 is a schematic structural diagram of a further display panel according to an embodiment of the present disclosure;
FIG. 13 is a timing diagram corresponding to a display panel according to an embodiment of the present disclosure;
FIG. 14 is a schematic structural diagram of a further display panel according to an embodiment of the present disclosure;
FIG. 15 is a simplified schematic structural diagram of a display panel according to an embodiment of the present disclosure;
FIG. 16 is a schematic structural diagram of a further display panel according to an embodiment of the present disclosure;
FIG. 17 is a schematic structural diagram of a further display panel according to an embodiment of the present disclosure;
FIG. 18 is a simplified schematic structural diagram of a further display panel according to an embodiment of the present disclosure;
FIG. 19 is a simplified schematic structural diagram of a further display panel according to an embodiment of the present disclosure;
FIG. 20 is a schematic structural diagram of a further display panel according to an embodiment of the present disclosure;
FIG. 21 is a schematic structural diagram of a further display panel according to an embodiment of the present disclosure;
FIG. 22 is a simplified schematic structural diagram of a further display panel according to an embodiment of the present disclosure;
FIG. 23 is a schematic diagram of a data line, a power supply signal line, a data lead and a light-emitting element according to an embodiment of the present disclosure;
FIG. 24 is a schematic diagram of a further data line, a further power supply signal line, a further data lead and a further light-emitting element according to an embodiment of the present disclosure;
FIG. 25 is a schematic structural diagram of a further display panel according to an embodiment of the present disclosure;
FIG. 26 is a schematic diagram of a further film layer structure of a display panel according to an embodiment of the present disclosure;
FIG. 27 is a schematic diagram of a further film layer structure of a display panel according to an embodiment of the present disclosure;
FIG. 28 is a schematic diagram of a further film layer structure of a display panel according to an embodiment of the present disclosure;
FIG. 29 is a cross-sectional view of FIG. 28 along A1-A2 direction; and
FIG. 30 is a schematic structural diagram of a display apparatus according to an embodiment of the present disclosure.

### DESCRIPTION OF EMBODIMENTS

In order to better understand the technical solutions of the present disclosure, embodiments of the present disclosure are described in detail below with reference to the drawings.

It should be understood that the embodiments described are merely part of the embodiments of the present disclosure, rather than all. Based on the embodiments of the present disclosure, all other embodiments obtained by those skilled in the art without creative effort fall within the protection scope of the present disclosure.

The terms used in the embodiments of the present disclosure are merely for the purpose of describing specific embodiments and are not intended to limit the present disclosure. The singular forms "a/an", "the" and "said" used in the embodiments of the present disclosure and the attached claims are also intended to include plural forms unless the context clearly indicates otherwise.

It should be understood that the term "and/or" used herein is merely a description of the relationship between associated objects, indicating that three possible relationships exist. For example, "A and/or B" can represent: A alone, both A and B, or B alone. In addition, the character "/" used herein generally indicates that the associated objects before and after are in an "or" relationship.

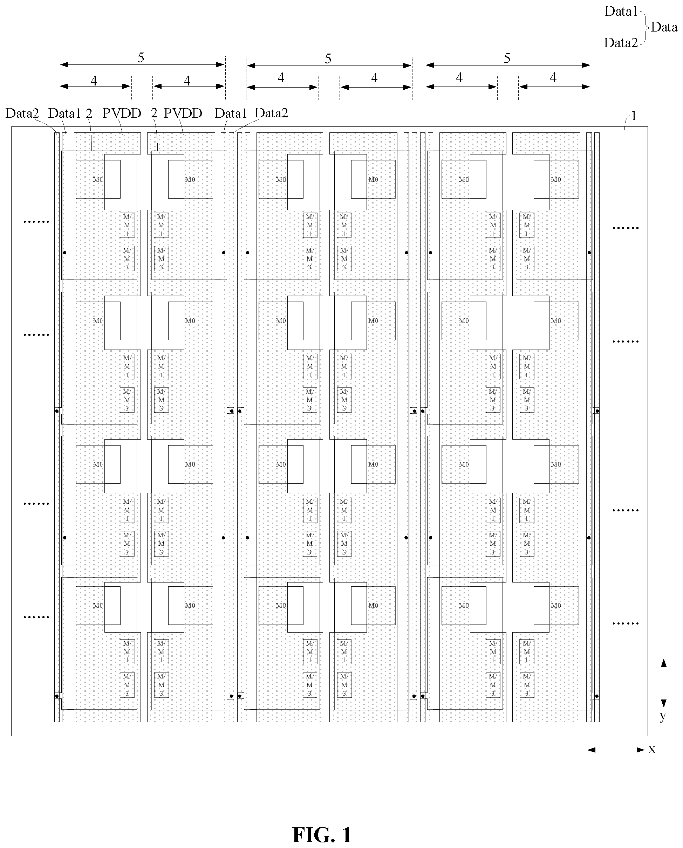

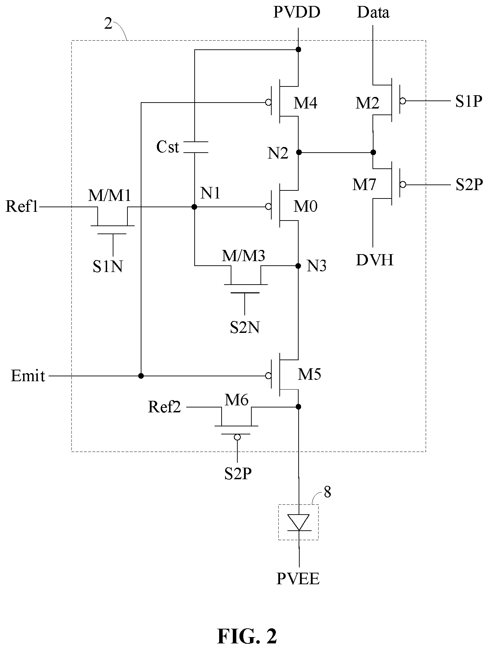

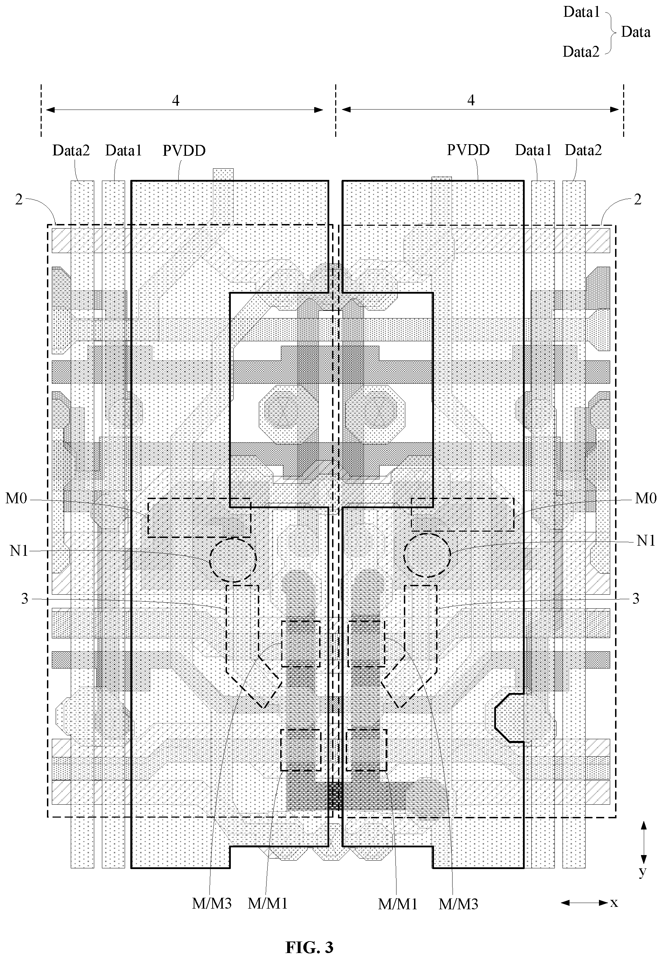

An embodiment of the present disclosure provides a display panel, as shown in FIG. 1 to FIG. 3, where FIG. 1 is a schematic structural diagram of a display panel according to an embodiment of the present disclosure, FIG. 2 is a schematic structural diagram of a pixel circuit according to an embodiment of the present disclosure, and FIG. 3 is a schematic diagram of a film layer structure of a display panel according to an embodiment of the present disclosure. The display panel includes a substrate 1. The substrate 1 may be a rigid substrate such as glass, or a flexible substrate such as polyimide (PI).

The display panel further includes a pixel circuit 2. The pixel circuit 2 includes a driving transistor M0 and at least one first transistor M. A gate of the driving transistor M0 is electrically connected to the first transistor M through a connection line 3. An active layer of the first transistor M includes a metal oxide semiconductor material, that is, the first transistor M is a metal oxide transistor. The off-state leakage current of such a transistor is small, which can effectively improve the current leakage problem of the gate of the driving transistor M0, i.e., a first node N1. In an embodiment of the present disclosure, the first transistor M may be an indium gallium zinc oxide (IGZO) transistor. The metal oxide semiconductor layer may optionally further include indium, gallium, zinc, tin, and oxygen. The metal oxide semiconductor layer may optionally further include binary compounds (ABx), ternary compounds (ABxCy), and quaternary compounds (ABxCyDz), such as those containing indium, zinc, gallium, tin, titanium, aluminum, hafnium (Hf), zirconium (Zr), and magnesium (Mg).

The display panel further includes a plurality of circuit columns 4 arranged along a first direction x. Each circuit column 4 includes a plurality of pixel circuits 2 arranged along a second direction y. The first direction x intersects the second direction y.

The display panel further includes a plurality of first circuit groups 5 arranged along the first direction x. Each first circuit group 5 includes two adjacent circuit columns 4. In the first circuit group 5, the first transistors M in two adjacent pixel circuits 2 in the first direction x are arranged adjacent to each other. In an embodiment of the present disclosure, two adjacent pixel circuits 2 in the first circuit group 5 in the first direction x can be symmetrically arranged along the second direction y, so that the first transistors M in the two pixel circuits 2 are adjacent to each other.

The display panel further includes data lines Data. The data lines Data includes a first data line Data 1 and a second data line Data 2. One of the first data line Data 1 and the second data line Data 2 is electrically connected to an odd-numbered pixel circuit 2 in the circuit column 4, and the other one of the first data line Data 1 and the second data line Data 2 is electrically connected to an even-numbered pixel circuit 2 in the circuit column 4.

The display panel further includes power supply signal lines PVDD. The power supply signal line PVDD is electrically connected to the circuit column 4. Specifically, one power supply signal line is electrically connected to a plurality of pixel circuits 2 in one circuit column 4.

With respect to the first data line Data1, the second data line Data2, and the power supply signal line PVDD connected to a single circuit column 4, the first data line Data1 and the second data line Data2 are both disposed on one side of the driving transistor M0 in the circuit column 4 away from the first transistor M, and the power supply signal line PVDD is disposed on one side of the first data line Data1 and the second data line Data2 adjacent to the first transistor M in the circuit column 4. It can be understood that the first data line and the second data line are both disposed on the same side of the power supply signal line.

Furthermore, in a direction perpendicular to the plane of the substrate 1, the power supply signal line PVDD overlaps the connection line 3 and the active layer of the first transistor M, respectively.

An embodiment of the present disclosure proposes a technical solution for a dual-data line panel structure with a large number of signal lines: by designing the arrangement of the pixel circuits 2 and the arrangement of the data lines Data in a matched manner, the routing design of the power supply signal lines PVDD can be optimized, thereby enabling the electrical signal lines to shield the metal oxide transistors (first transistors M) in the pixel circuits 2 and the connection lines 3 between the metal oxide transistors and the driving transistors M0.

Specifically, first, in the embodiment of the present disclosure, the arrangement of the pixel circuits 2 in the two circuit columns 4 in the first circuit group 5 is adjusted. The first transistors M in the adjacent pixel circuits 2 in two circuit columns 4 are arranged adjacent to each other, and thus the first transistors M in the two adjacent pixel circuits 2 can be arranged more concentrated and closer to the spacing area between the two circuit columns 4. Correspondingly, the distribution of the connection lines 3 in the two pixel circuits 2 is also relatively concentrated. Second, in the embodiment of the present disclosure, the first data line Data1 and the second data line Data2 that are connected to the single circuit column 4 are disposed on the side of the driving transistor M0 in the circuit column 4 away from the first transistor M. In this way, with respect to a single first circuit group 5, the data lines Data corresponding to the two circuit columns 4 are respectively distributed on opposite sides of the two circuit columns 4 and are relatively far apart, thereby freeing up routing space for the power supply signal lines PVDD in the middle position, so that two power supply signal lines PVDD corresponding to two circuit columns 4 are both disposed between the data lines Data distributed on the opposite sides. Furthermore, the power supply signal line PVDD can better cover the first transistor M and the connection line 3.

The power supply signal line PVDD covers the first transistor M, which can reduce the risk of light irradiating the active layer of the first transistor M and improve the device stability of the first transistor M. The power supply signal line PVDD covers the connection line 3, which can utilize the stable power supply voltage on the power supply signal line PVDD to stabilize the gate potential of the driving transistor M0, thereby improving the stability of the voltage of the first node N1.

In summary, in the embodiments of the present disclosure, by designing the arrangement of the pixel circuits 2 and the arrangement of the data lines Data in a matched manner, a larger routing space can be freed up for the power supply signal line PVDD in the dual-data line panel structure with complex routing, thereby providing more convenient conditions for the power supply signal line PVDD to shield the first transistor M and the connection line 3, so that the power supply signal line PVDD can better shield the first transistor M and the connection line 3 to optimize the circuit performance of the pixel circuit 2.

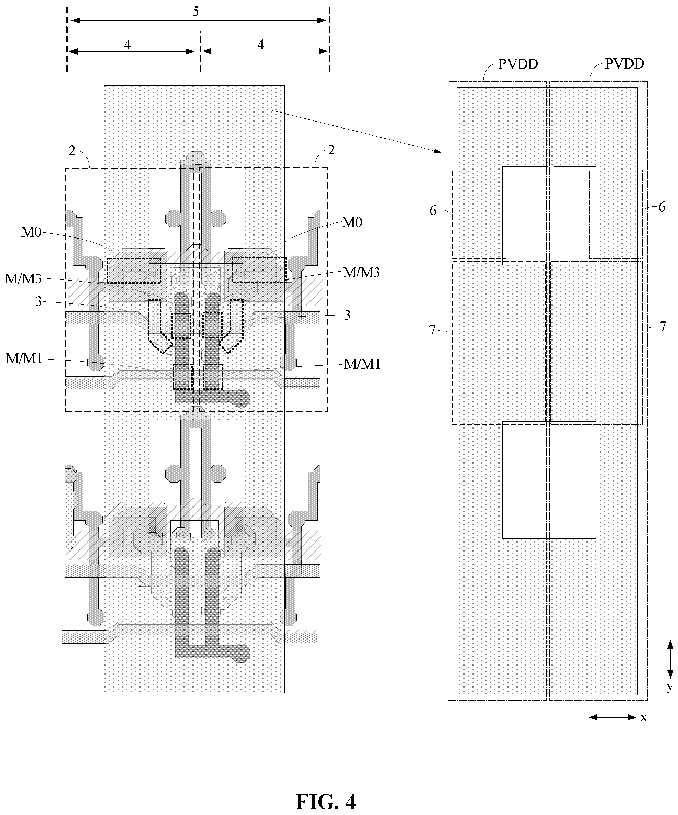

In a feasible implementation, as shown in FIG. 4, where FIG. 4 is a schematic diagram of a further film layer structure of a display panel according to an embodiment of the present disclosure, the power supply signal line PVDD includes a first line segment 6 and a second line segment 7 that are alternately arranged and sequentially connected in the second direction y. Along the first direction x, the width of the first line segment 6 is smaller than the width of the second line segment 7. In the direction perpendicular to the plane of the substrate 1, the second line segment 7 overlaps the connection line 3 and the active layer of the first transistor M, respectively.

In the two power supply signal lines PVDD connected to the first circuit group 5, the second line segments 7 of the two power supply signal lines PVDD are connected to each other.

Since the voltages on the power supply signal lines PVDD are consistent, there is no need to consider a short-circuit problem between the power supply signal lines PVDD. Therefore, when the two power supply signal lines PVDD corresponding to the first circuit group 5 are arranged adjacent to each other, the two power supply signal lines PVDD can be connected to each other, thereby providing a larger shielding area to better shield the first transistor M and the first node N1. Meanwhile, the voltage drop on the power supply signal lines PVDD can be reduced to ensure the display effect of the display panel.

Furthermore, in the embodiment of the present disclosure, the power signal line PVDD is not directly designed as a thick signal line with a uniform width, but instead is designed with a narrower first line segment 6 and a wider second line segment 7 that are alternately arranged. In this way, while the wider second line segment 7 is used to shield the first transistor M and the first node N1, a part of space can be freed up on one side of the first line segment 6, so that other lines on the same layer can be disposed at this position, thereby optimizing the layout design.

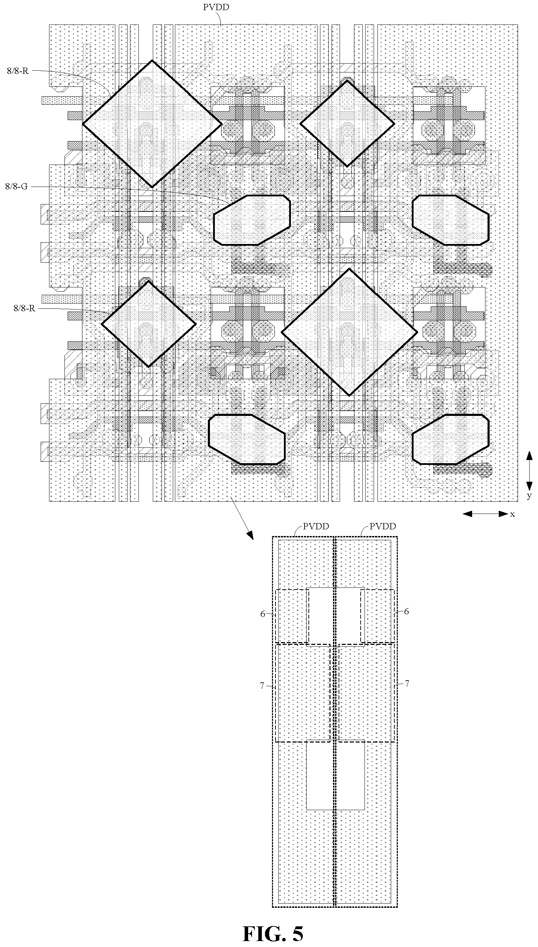

In a feasible implementation, as shown in FIG. 5, where FIG. 5 is a schematic diagram of a further film layer structure of a display panel according to an embodiment of the present disclosure, the display panel further includes a plurality of light-emitting elements 8. The light-emitting elements 8 include a green light-emitting element 8-G. In the direction perpendicular to the plane of the substrate 1, the green light-emitting element 8-G overlaps two power supply signal lines PVDD connected to the first circuit group 5.

Green light has a greater brightness, and it has a more noticeable impact on the display effect. Therefore, in an embodiment of the present disclosure, the green light-emitting element 8-G is disposed in the routing area where the power supply signal line PVDD is located. This allows the power supply signal line PVDD to overlap the anode of the green light-emitting element 8-G, shielding interference from other signals on the anode potential of the green light-emitting element 8-G, so that the potential of this anode is more stable, thereby improving the light-emitting effect of the green light-emitting element 8-G.

In addition, the line width of the power supply signal line PVDD is relatively large. Therefore, when the metal layer where the power supply signal line PVDD is located is adjacent to the metal layer where the anode of the light-emitting element 8 is located, the green light-emitting element 8-G is placed above the power supply signal line PVDD. The power supply signal line PVDD may also play a certain role in improving the flatness of the anode of the green light-emitting element 8-G.

Furthermore, with reference to FIG. 4 and referring to FIG. 5, in the direction perpendicular to the plane of the substrate 1, the green light-emitting element 8-G overlaps the second line segment 7 of the power supply signal line PVDD, thereby increasing the overlapping area between the power supply signal line PVDD and the green light-emitting element 8-G, shielding interference from other signals on the anode signal of the green light-emitting element 8-G to a greater extent, and improving the light-emitting reliability of the green light-emitting element 8-G.

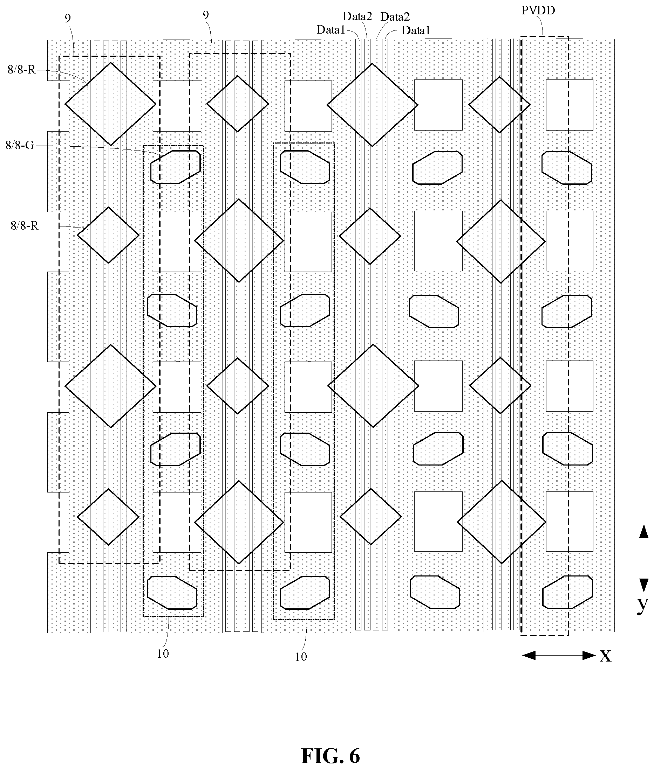

In a feasible implementation, as shown in FIG. 6, where FIG. 6 is a schematic diagram of a data line Data, a power supply signal line PVDD and a light-emitting element 8 according to an embodiment of the present disclosure, the light-emitting element 8 further includes a red light-emitting element 8-R and a blue light-emitting element 8-B.

The display panel further includes a first light-emitting element group 9 and a second light-emitting element group 10 that are alternately arranged along the first direction x. The first light-emitting element group 9 includes the red light-emitting element 8-R and the blue light-emitting element 8-B that are alternately arranged along the second direction y, and the second light-emitting element group 10 includes the green light-emitting elements 8-G arranged along the second direction y. More specifically, in an arrangement, in two adjacent first light-emitting element groups 9, the red light-emitting element 8-R in one first light-emitting element group 9 is aligned with the blue light-emitting element 8-B in the other first light-emitting element group 9.

In the direction perpendicular to the plane of the substrate 1, the second light-emitting element group 10 overlaps two power supply signal lines PVDD connected to the first circuit group 5, and the first light-emitting element group 9 overlaps four adjacent data lines Data without the driving transistor M0 interposed therebetween. The four adjacent data lines Data without the driving transistor M0 interposed therebetween refer to the four data lines Data corresponding to two adjacent circuit columns 4 in two adjacent first circuit groups 5.

On the premise that the green light-emitting element 8-G overlaps the power supply signal lines PVDD, the red light-emitting element 8-R and the blue light-emitting element 8-B are further arranged to overlap the four adjacent data lines Data without the driving transistor M0 interposed therebetween. On the one hand, this allows the overlapping of the light-emitting elements 8 with the data lines Data and the power supply signal lines PVDD to be more regular. On the other hand, when the metal layer where the data lines Data are located is adjacent to the metal layer where the anodes are located in the vertical direction, the four adjacent data lines Data can also have a certain effect on the flatness of the anodes of the red light-emitting element 8-R and the blue light-emitting element 8-B.

In a feasible implementation, with respect to the display panel of the present disclosure, a design in which part of the fan-out lines are arranged in the display area (Fanout in AA, FIAA) may also be further adopted.

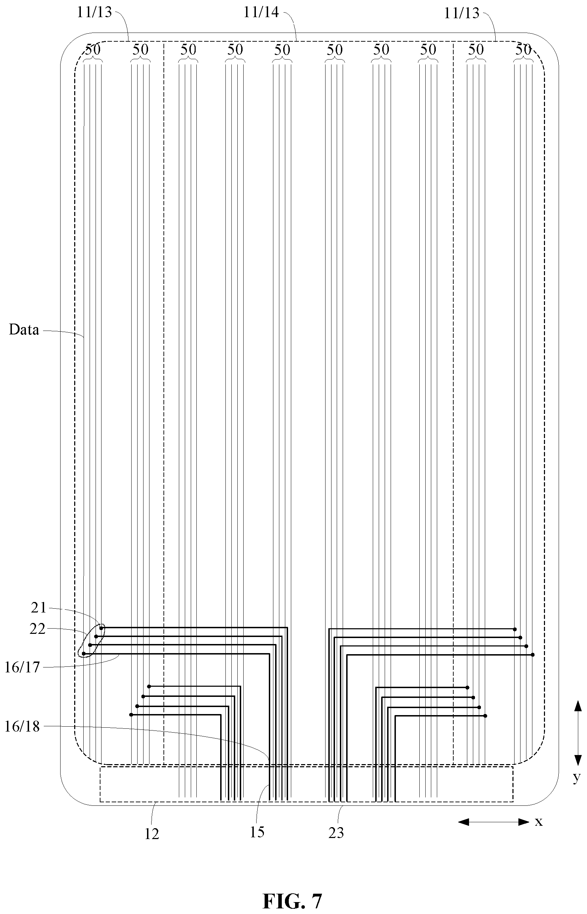

As shown in FIG. 7, where FIG. 7 is a schematic structural diagram of a display panel according to an embodiment of the present disclosure. The display panel further includes a display area 11 and a first non-display area 12. The display area 11 includes a first display area 13 and a second display area 14. The first display area 13 is located on at least one side of the second display area 14 in the first direction x, that is, the first display area 13 is closer to the outer edge of the display panel, serving as an edge display area. The total number of the data lines in the first display area 13 may optionally be substantially the same as the total number of the data lines in the second display area 14. The total number of the data lines in the first display area 13 may optionally be M, and the total number of the data lines in the second display area 14 may optionally be N, where 0.8≤M/N≤1.5. M/N may optionally be 1, 1.2, 1.25, 1.3, etc.

The first non-display area 12 includes a plurality of data connection wirings 15, and the data connection wirings 15 are electrically connected to the data lines Data.

The data lines Data in the first display area 13 are electrically connected to the data connection wirings 15 through data leads 16. The data leads 16 include a first data lead 17 and a second data lead 18. The first data lead 17 extends along the first direction x, and the second data lead 18 extends along the second direction y. The data leads 16 may optionally further include a plurality of first data leads 17 extending along the first direction x and a plurality of second data leads 18 extending along the second direction y.

In the above structure, the data lines Data in the edge display area may be led to the middle display area through the data leads 16, so that the data leads 16 connected to these data lines Data are led out from the middle lower position of the display area 11, thereby avoiding these data connection wirings 15 occupies a relatively large space in the corner bezel, and helping to optimize the narrow bezel design.

It should be noted that the wirings extending along the first direction x or the second direction y described in the embodiments of the present disclosure merely refers to an overall extending direction of the wirings. The wirings may specifically extend in a straight manner in that direction, or may extend in a zigzag manner in that direction.

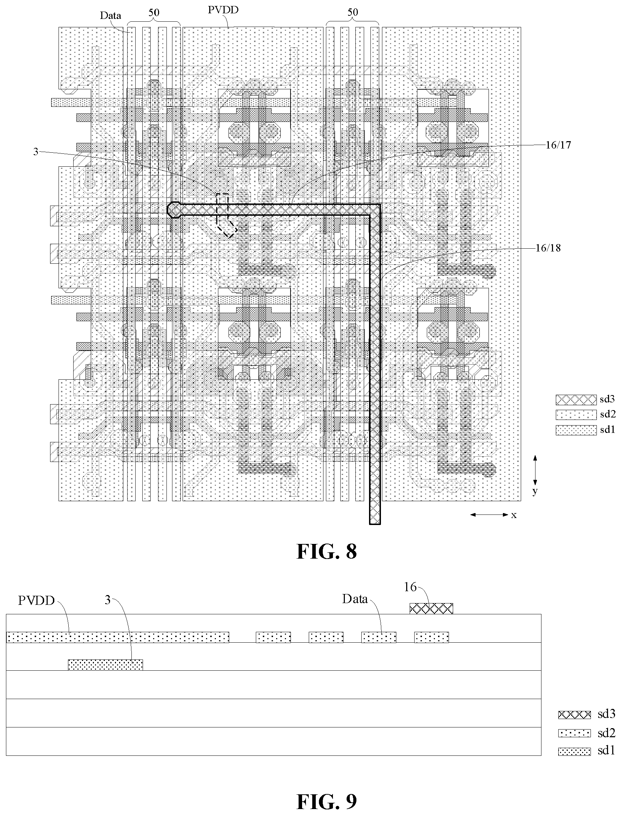

In a feasible implementation, as shown in FIG. 8 and FIG. 9, where FIG. 8 is a schematic diagram of a further film layer structure of a display panel according to an embodiment of the present disclosure, and FIG. 9 is a schematic cross-sectional view of a display panel according to an embodiment of the present disclosure. The display panel includes a source-drain layer sd1, a first wiring layer sd2, and a second wiring layer sd3. The first wiring layer sd2 is disposed on one side of the source-drain layer sd1 away from the substrate 1, and the second wiring layer sd3 is disposed on one side of the first wiring layer sd2 away from the substrate 1.

The connection line 3 is disposed on the source-drain layer sd1, the data line Data and the power supply signal line PVDD are disposed on the first wiring layer sd2, and the data lead 16 is disposed on the second wiring layer sd3.

It should be noted that the doped area of the active layer in the transistor is usually led to the upper metal layer through the connection electrode, and further electrically connected to other structures such as wiring. The source-drain layer sd1 serves as the metal layer in the display panel used to form the connection electrode.

In the above structure, the first data lead 17 and the second data lead 18 of the data leads 16 are routed on the second wiring layer sd3, and the data line Data and the power supply signal line PVDD are routed on the first wiring layer sd2. On the one hand, the second wiring layer sd3 is closer to the source-drain layer sd1, so that the power supply signal line PVDD can be closer to the active layer of the first transistor M and the connection line 3, thereby improving the light-shielding effect of the power supply signal line PVDD on the first transistor M and the shielding effect on the first node N1. On the other hand, the first data lead 17 and the second data lead 18 of the data leads 16 are disposed on the same layer, so that the first data lead 17 and the second data lead 18 do not need to be connected through vias, thereby reducing the number of vias.

In a feasible implementation, referring to FIG. 7, the data line Data is electrically connected to the first data lead 17 through a first via 21.

Four adjacent data lines Data without the driving transistor M0 interposed therebetween form a data line group 50, and four first vias 21 connected to one data line group 50 form a via group 22.

In the direction from the first display area 13 toward the second display area 14, the distances between a plurality of via groups 22 and a first edge 23 decrease, and the distances between the first vias 21 in a single via group 22 and the first edge 23 increase. The first edge 23 is an outer edge of the display panel extending along the first direction x.

Based on this arrangement of the vias, the data leads 16 connected to the plurality of data lines Data in the first display area 13 may be arranged to avoid each other, thereby avoiding short circuits.

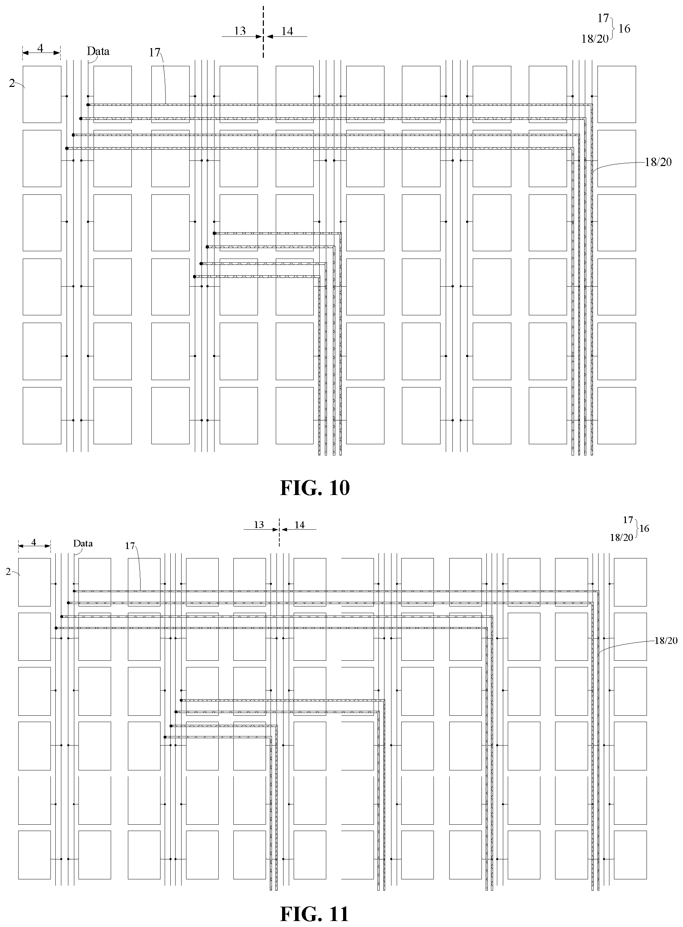

In a feasible implementation, as shown in FIG. 10, where FIG. 10 is a schematic structural diagram of a further display panel according to an embodiment of the present disclosure, the second data lead 18 includes a first lead 20. In the direction perpendicular to the plane of the substrate 1, the first lead 20 overlaps the data line Data. In this case, the routing space occupied by the first lead 20 substantially coincides with the routing space occupied by the data line Data, which can reduce the overall reflectivity of the display panel.

Furthermore, as shown in FIG. 11, where FIG. 11 is a schematic structural diagram of a further display panel according to an embodiment of the present disclosure, at most two data lines Data among the four data lines Data connected to two adjacent circuit columns 4 overlap the first lead 20.

The four adjacent data lines Data without the driving transistor M0 interposed therebetween are arranged relatively densely. When at most two of the data lines Data connected to two adjacent circuit columns 4 overlap the first lead 20, this means that at most two of the four densely arranged data lines Data overlap the first lead 20, thereby reducing the coupling between these data lines Data and the first lead 20 and decreasing signal interference.

In a feasible implementation, to reduce the number of pins and lower costs, the display panel of the present disclosure may further adopt a Demux design.

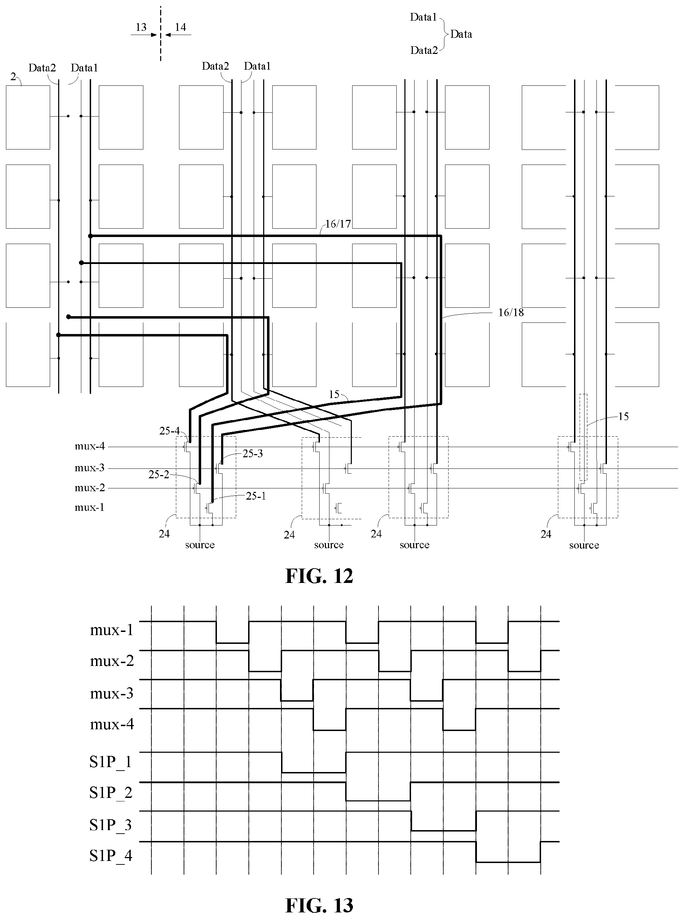

As shown in FIG. 12, where FIG. 12 is a schematic structural diagram of a further display panel according to an embodiment of the present disclosure. The display panel further includes a plurality of demux circuits 24 and 4m clock lines mux. The demux circuit 24 includes 4m gating switches 25, where m is a positive integer greater than or equal to 1.

In the demux circuit 24, the control ends of 4m gating switches 25 are electrically connected to 4m clock lines mux, respectively; and the output ends of the 4m gating switches 25 are electrically connected to a source signal line source. The output ends of 2m gating switches 25 are coupled to 2m first data lines Data1, respectively; and the output ends of the other 2m second gating switches 25 are coupled to 2m second data lines Data2, respectively.

It should be noted that in the FIAA design, with respect to the data lines Data in the second display area 14, these data lines Data may be directly connected to the corresponding gating switches 25 through the data connection wirings 15. When the gating switch 25 is turned on, the signal on the source signal line source is transmitted to the data line Data through the gating switch 25 and the data connection wiring 15. However, with respect to the data lines Data in the first display area 13, these data lines Data need to be connected to the data leads 16, and then connected to the corresponding gating switches 25 through the data connection wirings 15. When the gating switch 25 is turned on, the signal on the source signal line source is transmitted to the data line Data through the gating switch 25, the data connection wiring 15, and the data lead 16.

In addition, it should be noted that FIG. 12 is merely intended to illustrate the connection relationship between the data lines Data and the demux circuits 24, and does not limit the distribution position of the data leads 16.

In the following, the operation process of the display panel is illustrated by taking m=1 as an example in an embodiment of the present disclosure.

In the drawings, the four gating switches in the demux circuit 24 are illustrated with reference signs 25-1 to 25-4, and the four clock lines are illustrated with reference signs mux-1 to mux-4.

With reference to FIG. 2, FIG. 12 and FIG. 13, where FIG. 13 is a timing diagram corresponding to a display panel according to an embodiment of the present disclosure. In FIG. 13, S1P_i represents the signal provided by a third scanning line S1P connected to the i-th row of pixel circuits 2.

Before the scan signal S1P_1 corresponding to the first row of pixel circuits 2 is set to a low level, signals on the clock line mux-1 and the clock line mux-2 are sequentially set to the low levels. When the signal on the clock line mux-1 is set to the low level, the gating switch 25-1 is turned on, and the data voltage on the source signal line source is written to the first data line Data1 coupled to the gating switch 25-1. Then, when the signal on the clock line mux-2 is set to the low level, the gating switch 25-2 is turned on, and the data voltage on the source signal line source is written to the first data line Data1 coupled to the gating switch 25-2. Furthermore, when the scan signal S1P_1 is set low, the data voltages in these first data lines Data1 are further written to the first row of pixel circuits 2, thereby charging the pixel circuits 2 in that row.

Before the scan signal S1P_2 corresponding to the second row of pixel circuits 2 is set to a low level, signals on the clock line mux-3 and the clock line mux-4 are sequentially set to low levels. When the signal on the clock line mux-3 is set to the low level, the gating switch 25-3 is turned on, and the data voltage on the source signal line source is written to the second data line Data2 coupled to the gating switch 25-3. Then, when the signal on the clock line mux-4 is set to the low level, the gating switch 25-4 is turned on, and the data voltage on the source signal line source is written to the second data line Data2 coupled to the gating switch 25-4. Furthermore, when the scan signal S1P_2 is set low, the data voltages in these second data lines Data2 are further written to the second row of pixel circuits 2, thereby charging the pixel circuits 2 in that row.

Before the scan signal S1P_3 corresponding to the third row of pixel circuits 2 is set to the low level, the signals on the clock line mux-1 and the clock line mux-2 are sequentially set to the low level. When the signal on the clock line mux-1 is set to the low level, the gating switch 25-1 is turned on, and the data voltage on the source signal line source is written to the first data line Data1 coupled to the gating switch 25-1. Then, when the signal on the clock line mux-2 is set to the low level, the gating switch 25-2 is turned on, and the data voltage on the source signal line source is written to the first data line Data1 coupled to the gating switch 25-2. Furthermore, when the scan signal S1P_3 is set low, the data voltages in these first data lines Data1 are further written to the third row of pixel circuits 2, thereby charging the pixel circuits 2 in that row.

Before the scan signal S1P_4 corresponding to the fourth row of pixel circuits 2 is set to the low level, the signals on the clock line mux-3 and the clock line mux-4 are sequentially set to the low levels. When the signal on the clock line mux-3 is set to the low level, the gating switch 25-3 is turned on, and the data voltage on the source signal line source is written to the second data line Data2 coupled to the gating switch 25-3. Then, when the signal on the clock line mux-4 is set to the low level, the gating switch 25-4 is turned on, and the data voltage on the source signal line source is written to the second data line Data2 coupled to the gating switch 25-4. Furthermore, when the scan signal S1P_4 is set low, the data voltages in these second data lines Data2 are further written to the fourth row of pixel circuits 2, thereby charging the pixel circuits 2 in that row.

The same applies to the following.

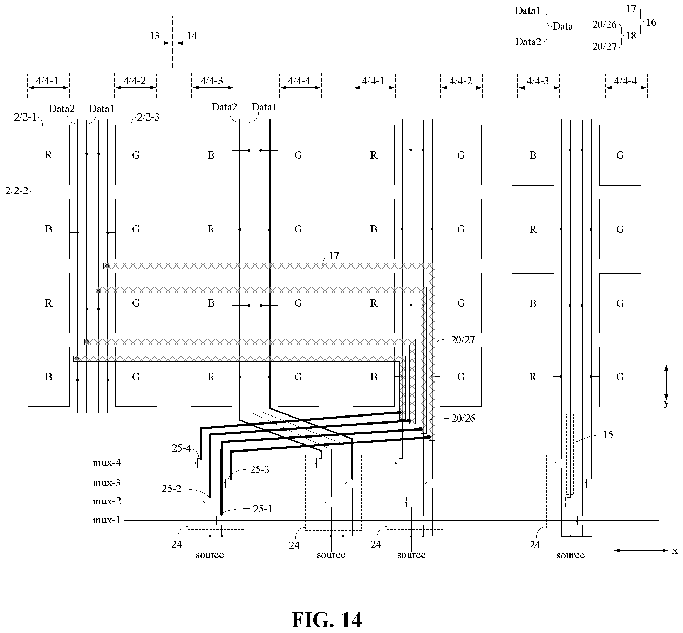

After the display panel adopts the Demux design, regarding the first lead 20, in a feasible implementation, as shown in FIG. 14, where FIG. 14 is a schematic structural diagram of a further display panel according to an embodiment of the present disclosure, with respect to the first lead 20 and the data line Data overlapping therewith, the gating switches 25 coupled to the first lead 20 and the data line Data are electrically connected to the same clock line mux.

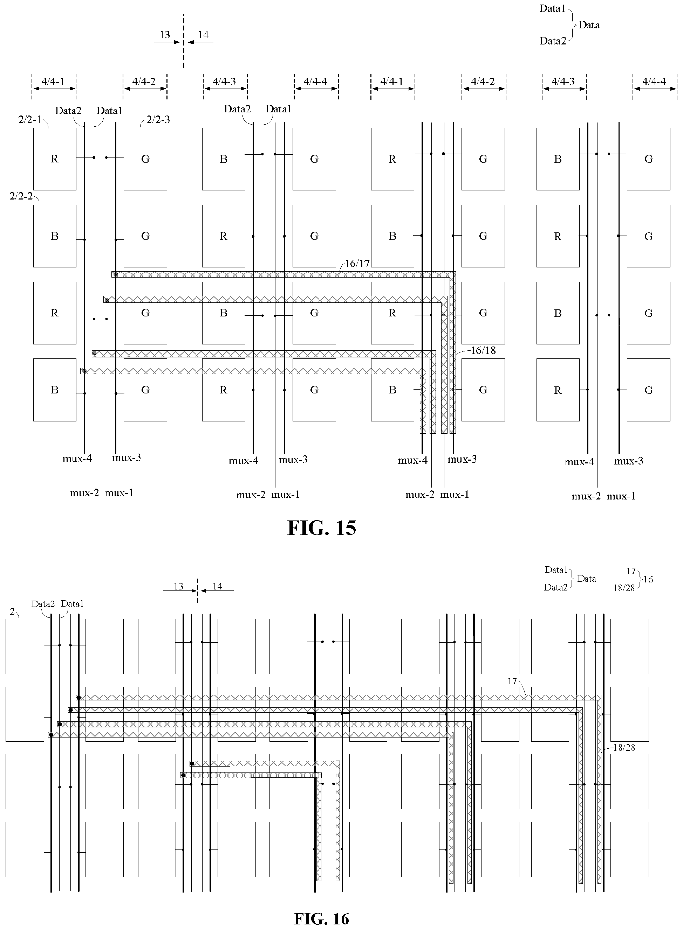

For a clearer illustration, referring to FIG. 15, where FIG. 15 is a simplified schematic structural diagram of a display panel according to an embodiment of the present disclosure. In FIG. 15, the clock line mux indicated below the data line Data refers to the clock line mux connected to the gating switch 25 coupled to the data line Data. In the first display area 13, the corresponding clock line mux below the data line Data specifically refers to the clock line mux corresponding to the first lead 20 connected to the data line Data. In FIG. 15, it can be clearly seen that the first lead 20 and the data line Data overlapping therewith correspond to the same clock line mux.

From the above description of the operation process of the display panel, it can be seen that when the gating switch 25 is turned on, the data voltage on the source signal line source is further transmitted to the data line Data coupled to the source signal line source through the gating switch 25. Since the gating switches 25 connected to the same clock line mux are turned on and off simultaneously, when the gating switches 25 coupled to the first lead 20 and the data line Data overlapping with the first lead 20 are connected to the same clock line mux, it means that the data voltage will write in and stop writing in the first lead 20 and the data line overlapping with the first lead 20 simultaneously. In this way, the voltage transition instants on these signal lines are aligned, which can reduce the crosstalk between the first lead 20 and the data line Data overlapping therewith, and lower the coupling effect between the first lead 20 and the data line Data.

Furthermore, with respect to the first lead 20 and the data line Data overlapping with the first lead 20, the pixel circuit 2 coupled to the first lead 20 and the pixel circuit 2 coupled to the data line Data can be electrically connected to the light-emitting elements of the same color, so that when the gating switch 25 is turned on, the first lead 20 and the data line Data transmit the data voltage required by the light-emitting elements of the same color, which can further reduce the impact of coupling on the display effect.

For example, referring to FIG. 14, the pixel circuits 2 includes a first pixel circuit 2-1, a second pixel circuit 2-2, and a third pixel circuit 2-3. The first pixel circuit 2-1 is configured to be electrically connected to the red light-emitting element 8-R (not shown), the second pixel circuit 2-2 is configured to be electrically connected to the green light-emitting element 8-G (not shown), and the third pixel circuit 2-3 is configured to be electrically connected to the blue light-emitting element 8-B (not shown). For ease of distinction, in the drawings, R is marked in the first pixel circuit 2-1, G is marked in the second pixel circuit 2-2, and B is marked in the third pixel circuit 2-3.

The plurality of circuit columns 4 include a first circuit sub-column 4-1, a second circuit sub-column 4-2, a third circuit sub-column 4-3, and a fourth circuit sub-column 4-4 that are sequentially and alternately arranged along the first direction x. The first circuit sub-column 4-1 includes the first pixel circuit 2-1 and the third pixel circuit 2-3 that are alternately arranged along the second direction y. The third circuit sub-column 4-3 includes the third pixel circuit 2-3 and the first pixel circuit 2-1 that are alternately arranged along the second direction y. Moreover, the first pixel circuit 2-1 in the first circuit sub-column 4-1 is aligned with the third pixel circuit 2-3 in the third circuit sub-column 4-3. The second circuit sub-column 4-2 and the fourth circuit sub-column 4-4 each include second pixel circuits 2-2 arranged along the second direction y.

At least some of the first leads 20 and the data lines Data overlapping with the first leads 20 are respectively coupled to the first circuit sub-column 4-1, and/or at least some of the first leads 20 and the data lines Data overlapping with the first leads 20 are respectively coupled to the second circuit sub-column 4-2, and/or at least some of the first leads 20 and the data lines Data overlapping with the first leads 20 are respectively coupled to the third circuit sub-column 4-3, and/or at least some of the first leads 20 and the data lines Data overlapping with the first leads 20 are respectively coupled to the fourth circuit sub-column 4-3.

Regarding the more specific structure of the first lead 20, referring to FIG. 14, the first lead 20 includes a first sub-lead 26. The first sub-lead 26 is electrically connected to a first data line Data1 in the first display area 13 and overlaps a first data line Data1 in the second display area 14. The gating switches 25 coupled to the first sub-lead 26 and the first data line Data1 overlapping with the first sub-lead 26 are electrically connected to the same clock line mux, thereby reducing the crosstalk between the first sub-lead 26 and the first data line Data1 overlapping therewith, and lowering the coupling effect between the first sub-lead 26 and the first data line Data1.

Meanwhile or alternatively, the first lead 20 further includes a second sub-lead 27. The second sub-lead 27 is electrically connected to the second data line Data2 in the first display area 13 and overlaps the second data line Data2 in the second display area 14. The gating switches 25 coupled to the second sub-lead 27 and the second data line Data2 overlapping with the second sub-lead 27 are electrically connected to the same clock line mux, thereby reducing the crosstalk between the second sub-lead 27 and the second data line Data2 overlapping therewith, and lowering the coupling effect between the second sub-lead 27 and the second data line Data2.

In a feasible implementation, as shown in FIG. 16, where FIG. 16 is a schematic structural diagram of a further display panel according to an embodiment of the present disclosure, the second data lead 18 includes a second lead 28, and the second lead 28 is disposed between adjacent data lines Data without the driving transistor M0 interposed therebetween. Such a second lead 28 does not overlap the data line Data, and the coupling between the second lead 28 and the data line Data is small, thereby reducing signal interference between the second lead 28 and the data line Data.

Furthermore, referring to FIG. 16, the second lead 28 is disposed between the first data line Data1 and the second data line Data2 that are connected to the same circuit column 4. In this way, with respect to four adjacent data lines Data without the driving transistor M0 interposed therebetween, at most two second leads 28 are disposed between the four data lines Data, thereby further reducing the coupling between the data lead 16 and the data lines Data.

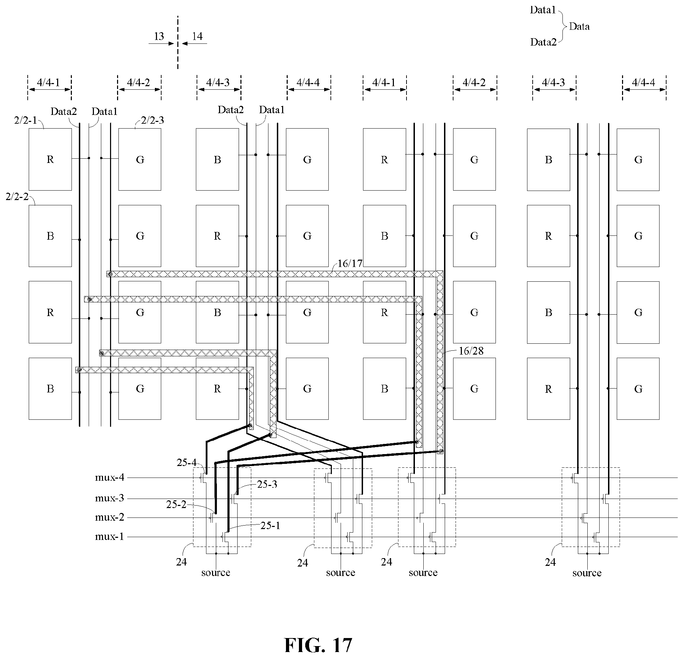

In a feasible implementation, as shown in FIG. 17, where FIG. 17 is a schematic structural diagram of a further display panel according to an embodiment of the present disclosure. The display panel further includes a plurality of demux circuits 24 and 4m clock lines mux. The demux circuit 24 includes 4m gating switches 25, where m is a positive integer greater than or equal to 1.

In the demux circuit 24, the control ends of 4m gating switches 25 are electrically connected to 4m clock lines mux, respectively, and the output ends of the 4m gating switches 25 are electrically connected to a source signal line source. The output ends of 2m gating switches 25 are coupled to 2m first data lines Data1, respectively; and the output ends of the other 2m second gating switches 25 are coupled to 2m second data lines Data2, respectively.

With respect to the second lead 28 and one of the data lines Data adjacent to the second lead 28, the gating switches 25 coupled to the second lead 28 and the one of the data lines Data are electrically connected to the same clock line mux.

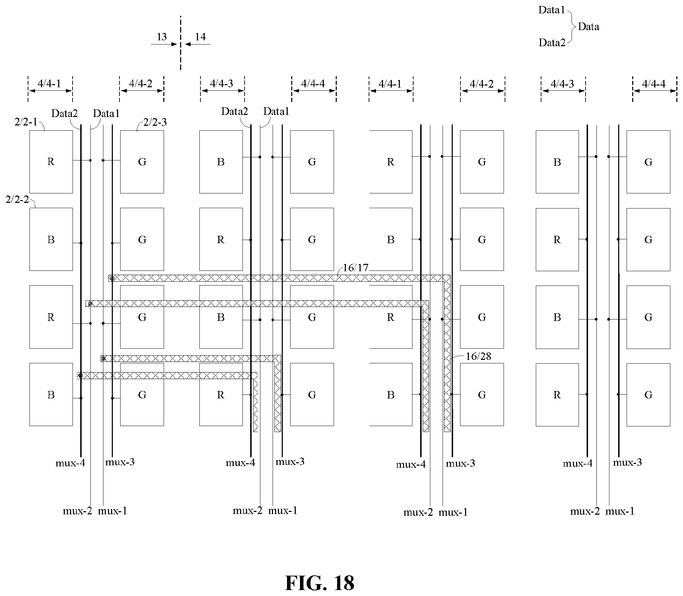

For a clearer illustration, referring to FIG. 18, where FIG. 18 is simplified schematic structural diagram of a further display panel according to an embodiment of the present disclosure. In FIG. 18, the clock line mux indicated below the data line Data refers to the clock line mux connected to the gating switch 25 coupled to the data line Data. In the first display area 13, the corresponding clock line mux below the data line Data specifically refers to the clock line mux corresponding to the second lead 28 connected to the data line Data. In FIG. 18, it can be clearly seen that the second lead 28 and the data line Data overlapping therewith correspond to the same clock line mux.

From the above description of the operation process of the display panel, it can be seen that when the gating switch 25 is turned on, the data voltage on the source signal line source is transmitted to the data line Data coupled to the source signal line source through the gating switch 25. Since the gating switches 25 connected to the same clock line mux are turned on and off simultaneously, when the gating switches 25 coupled to the second lead 28 and one of the data lines Data adjacent to the second lead 28 are connected to the same clock line mux, the data voltage will write in and stop writing in the second lead 28 and the data line adjacent to the second lead 28, so that the voltage transition instants on these signal lines are aligned, which can reduce the crosstalk between the second lead 28 and the data line Data overlapping therewith, and lower the coupling effect between the second lead 28 and the data line Data.

Furthermore, with respect to the second lead 28 and one of the data lines Data adjacent to the second lead 28, the pixel circuit 2 coupled to the second lead 28 and one of the data lines Data can be electrically connected to the light-emitting elements of the same color, so that when the gating switch 25 is turned on, the first lead 20 and the data line Data transmit the data voltage required by the light-emitting elements of the same color is transmitted on , which can further reduce the impact of coupling on the display effect.

It should be noted that, in the above embodiments, there may be multiple ways to connect the data line Data and the gating switch 25 in the demux circuit 24.

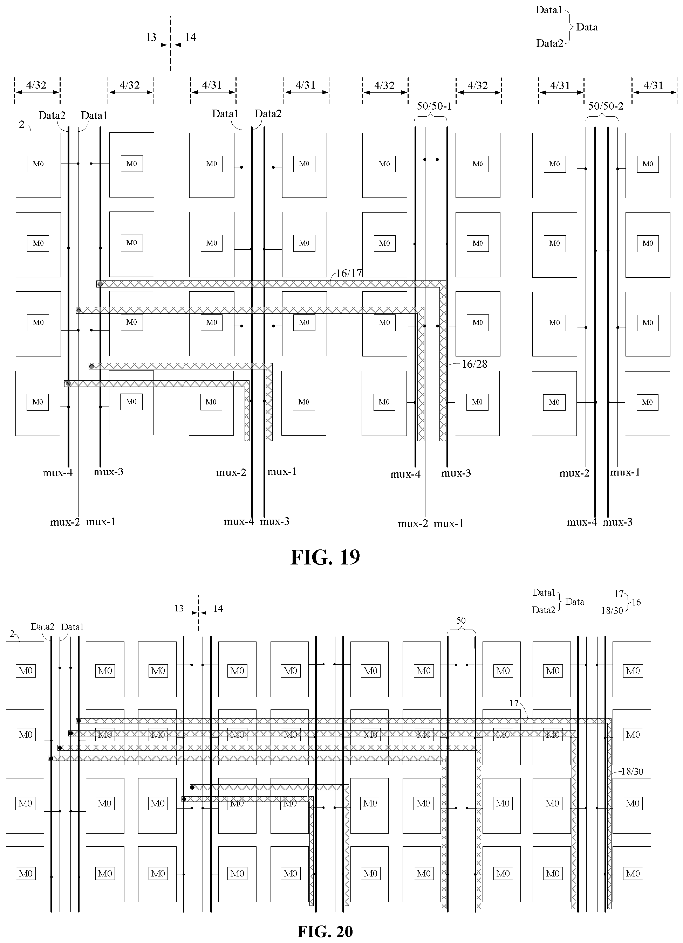

For example, as shown in FIG. 19, FIG. 19 is a simplified schematic structural diagram of a further display panel according to an embodiment of the present disclosure. The circuit column 4 includes a first circuit column 31 and a second circuit column 32. The first data line Data1 connected to the first circuit column 31 is disposed on one side of the second data line Data2 adjacent to the driving transistor M0, and the second data line Data2 connected to the second circuit column 32 is disposed on one side of the first data line Data1 adjacent to the driving transistor M0.

In the above structure, the data line group 50 includes a first data line group 50-1 and a second data line group 50-2 that are alternately arranged. The clock lines mux corresponding to the four data lines Data in the first data line group 50-1 are arranged in the order mux4-mux2-mux1-mux3, and the clock lines mux corresponding to the four data lines Data in the second data line group 50-2 are arranged in the order mux2-mux4-mux3-mux1. In this way, the gating switches 25 coupled to the second lead 28 and one of the data lines Data adjacent to the second lead 28 can still be electrically connected to the same clock line mux.

In a feasible implementation, as shown in FIG. 20, where FIG. 20 is schematic structural diagram of a further display panel according to an embodiment of the present disclosure, four adjacent data lines Data without the driving transistor M0 interposed therebetween form a data line group 50.

The second data lead 18 includes a third lead 30. The third lead 30 is disposed on at least one side of the data line group 50, that is, the third lead 30 is disposed outside the four data lines Data without the driving transistor M0 interposed therebetween.

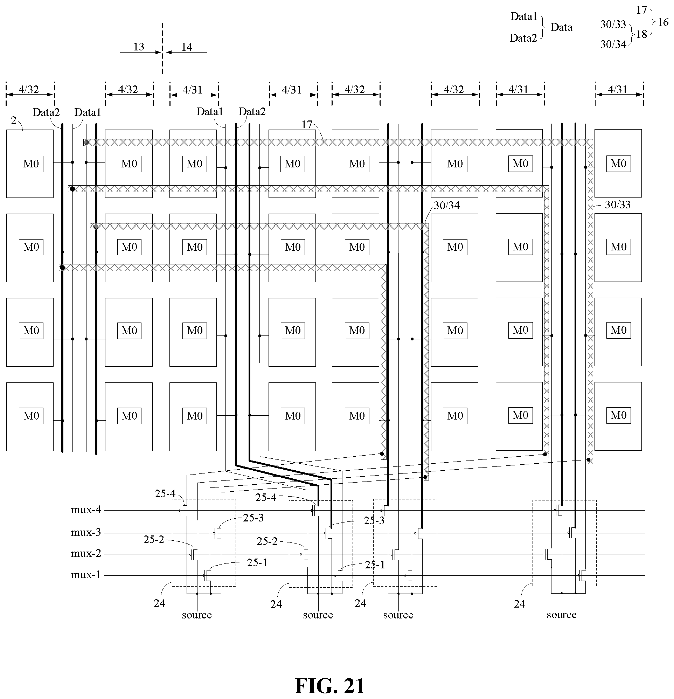

Furthermore, as shown in FIG. 21, where FIG. 21 is a schematic structural diagram of a further display panel according to an embodiment of the present disclosure. The display panel further includes a plurality of demux circuits 24 and 4m clock lines mux. The demux circuit 24 includes 4m gating switches 25, where m is a positive integer greater than or equal to 1.

In the demux circuit 24, the control ends of 4m gating switches 25 are electrically connected to 4m clock lines mux, respectively, and the output ends of the 4m gating switches 25 are electrically connected to a source signal line source. The output ends of 2m gating switches 25 are coupled to 2m first data lines Data1, respectively; and the output ends of the other 2m second gating switches 25 are coupled to 2m second data lines Data2, respectively.

In an embodiment of the present disclosure, the circuit column 4 includes the first circuit column 31 and the second circuit column 32. The first data line Data1 connected to the first circuit column 31 is disposed on the side of the second data line Data2 adjacent to the driving transistor M0, and the second data line Data2 connected to the second circuit column 32 is disposed on the side of the first data line Data1 adjacent to the driving transistor M0.

Furthermore, with respect to the third lead 30 and the data line Data adjacent to the third lead 30, the gating switches 25 coupled to the third lead 30 and the data line Data are electrically connected to the same clock line mux.

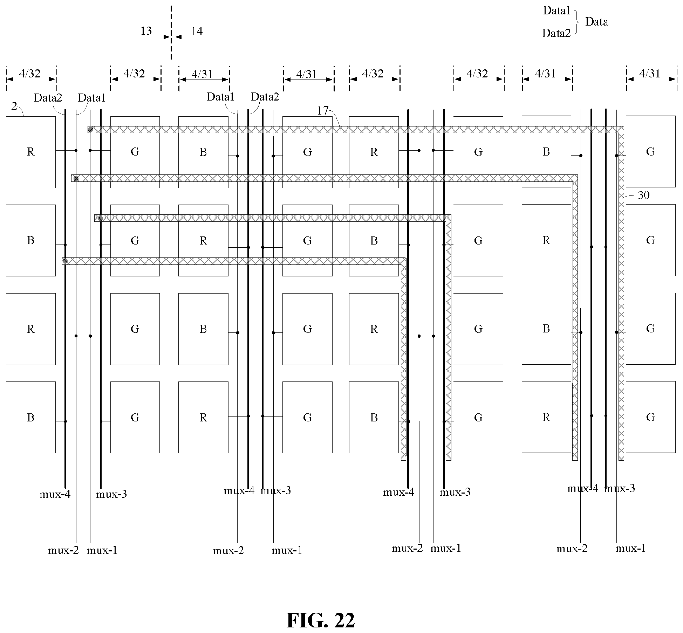

For a clearer illustration, referring to FIG. 22, where FIG. 22 is a simplified schematic structural diagram of a further display panel according to an embodiment of the present disclosure. In FIG. 22, the clock line mux indicated below the data line Data refers to the clock line mux connected to the gating switch 25 coupled to the data line Data. In the first display area 13, the corresponding clock line mux below the data line Data specifically refers to the clock line mux corresponding to the second lead 28 connected to the data line Data. In FIG. 22, it can be clearly seen that the third lead 30 and the data line Data overlapping therewith correspond to the same clock line mux.

By designing the arrangement of the data lines Data corresponding to the first circuit column 31 and the second circuit column 32 in a differentiated manner, the data line Data corresponding to any clock line mux can be disposed at the outermost side of the data line group 50, thereby enabling the third lead 30 corresponding to any clock line mux to be disposed adjacent to the data line Data corresponding to the same clock line mux.

The data line Data corresponding to the clock line mux is the data line Data coupled to the gating switch 25 connected to the clock line mux, and the third lead 30 corresponding to the clock line mux is the third lead 30 coupled to the gating switch 25 connected to the clock line mux.

From the above description of the operation process of the display panel, it can be seen that when the gating switches 25 coupled to the third lead 30 and the data line Data adjacent to the third lead 30 are electrically connected to the same clock line mux, it means that the voltage transition instants on the third lead 30 and the data line Data adjacent to the third lead 30 are synchronized, which can reduce the crosstalk between the third lead 30 and the data line Data adjacent to the third lead 30, and lower the coupling effect between the third lead 30 and the data line Data.

More specifically, referring to FIG. 21, the third lead 30 includes a third sub-lead 33. The third sub-lead 33 is electrically connected to the first data line Data1 and is adjacent to another first data line Data1. In addition, with respect to two first data lines Data1 respectively connected to the third sub-lead 33 and adjacent to the third sub-lead 33, the gating switches 25 connected to the two first data lines Data1 are electrically connected to the same clock line mux, so as to reduce the crosstalk between the third sub-lead 33 and the first data lines Data1 adjacent to the third sub-lead 33, and lower the coupling effect between the third sub-lead 33 and the first data lines Data1.

Meanwhile or alternatively, the third lead 30 further includes a fourth sub-lead 34. The fourth sub-lead 34 is electrically connected to the second data line Data2 and is adjacent to another second data line Data2. In addition, with respect to the two second data lines Data2 respectively connected to the fourth sub-lead 34 and adjacent to the fourth sub-lead 34, the gating switches 25 connected to the two second data lines Data2 are electrically connected to the same clock line mux, so as to reduce the crosstalk between the fourth sub-lead 34 and the second data line Data2 adjacent to the fourth sub-lead 34, and lower the coupling effect between the fourth sub-lead 34 and the second data line Data2.

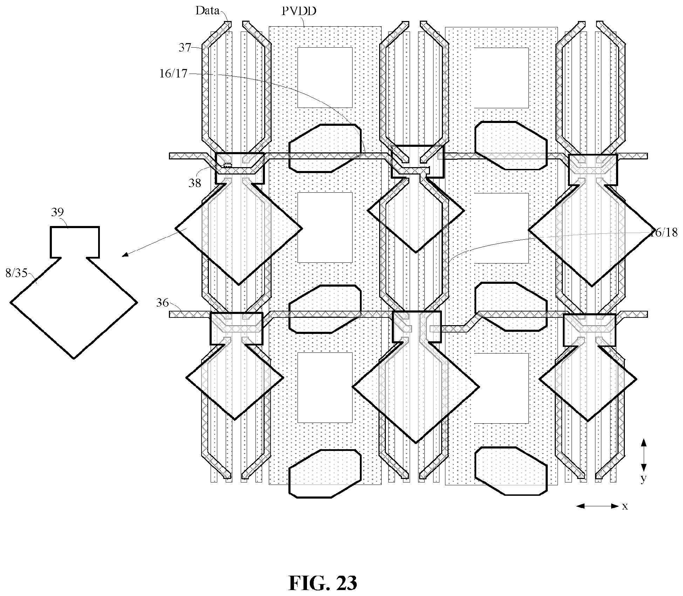

In a feasible embodiment, as shown in FIG. 23, where FIG. 23 is a schematic structural diagram of a further display panel according to an embodiment of the present disclosure, the display panel further includes light-emitting elements 8. The light-emitting element 8 includes an anode 35. The display panel may further include a pixel definition layer (not shown in the drawings). The pixel definition layer may at least partially cover the anode of the light-emitting element. The pixel definition layer may include a plurality of openings, and the openings expose at least a portion of the anodes. It can be understood that the light-emitting material of the light-emitting element is at least partially disposed within the opening in the pixel definition layer corresponding to the anode of the light-emitting element 8.

The display panel further includes a first wiring 36 and a second wiring 37. The first wiring 36 is disposed on the same layer and extends in the same direction as the first data lead 17, and the second wiring 37 is disposed on the same layer and extends in the same direction as the second data lead 18. Furthermore, breaks 38 are provided between the first wiring 36 and the first data lead 17, and between the second wiring 37 and the second data lead 18. Since the data leads 16 are generally distributed only within a portion of the display area, the first wiring 36 and the second wiring 37 may be disposed in areas outside of the data leads 16 to improve etching uniformity during the manufacturing process.

The display panel further includes a shielding portion 39. The shielding portion 39 and the anode 35 are disposed on the same layer and are connected to each other. It can be understood that the shielding portion 39 does not overlap the opening in the pixel definition layer of the light-emitting element. In the direction perpendicular to the plane of the substrate 1, the shielding portion 39 overlaps the break 38, so that a metal film layer is present above the break 38 for shielding, thereby improving the reflection uniformity at the position of the break 38 and at other positions.

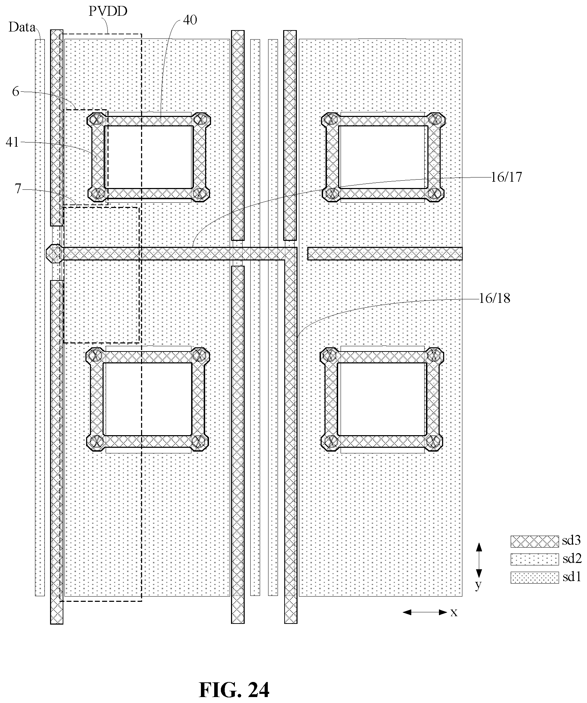

In a feasible embodiment, as shown in FIG. 24, where FIG. 24 is a schematic structural diagram of a further display panel according to an embodiment of the present disclosure, the power supply signal line PVDD includes the first line segment 6 and the second line segment 7 that are alternately arranged and sequentially connected in the second direction y. In the direction perpendicular to the plane of the substrate 1, the second line segment 7 overlaps the connection line 3 and the active layer of the first transistor M, and the width of the second line segment 7 in the first direction x is larger than the width of the first line segment 6 in the first direction x.

With respect to the two power supply signal lines PVDD connected to the first circuit group 5, a first auxiliary power supply line 40 is connected between the first line segments 6 of the two power supply signal lines PVDD, and/or a second auxiliary power supply line 41 is disposed in parallel with the first line segment 6.

Since the first line segment 6 of the power supply signal line PVDD is relatively narrow, the load at this position differs from the load at the position of the second line segment 7. By providing the first auxiliary power supply line 40 and/or the second auxiliary power supply line 41, these auxiliary power supply lines can be used to reduce the load at the position of the first line segment 6, thereby improving the load uniformity at different positions of the power supply signal line PVDD.

Furthermore, the first auxiliary power supply line 40 extends along the first direction x and may be disposed on the same layer as the first data lead 17. The second auxiliary power supply line 41 extends along the second direction y and may be disposed on the same layer as the second data lead 18. When both the first data lead 17 and the second data lead 18 are disposed on the second wiring layer sd3, the first auxiliary power supply line 40 and the second auxiliary power supply line 41 are also disposed on the second wiring layer sd3.

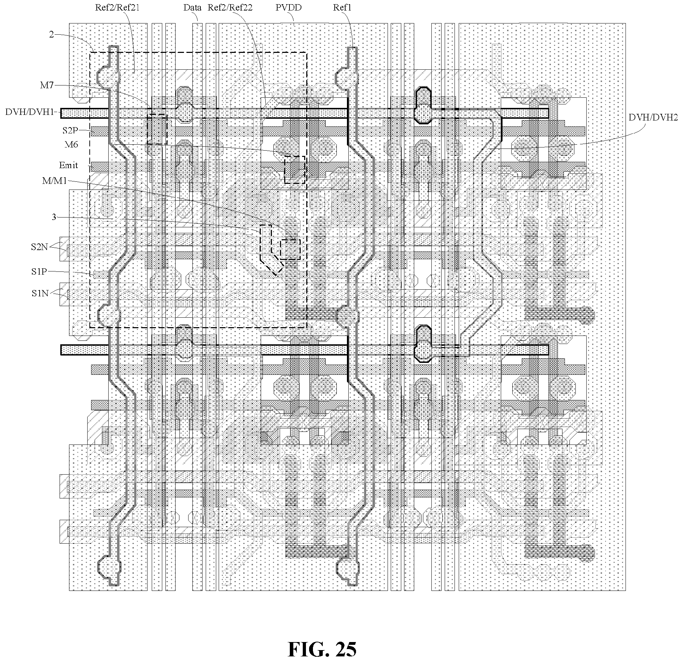

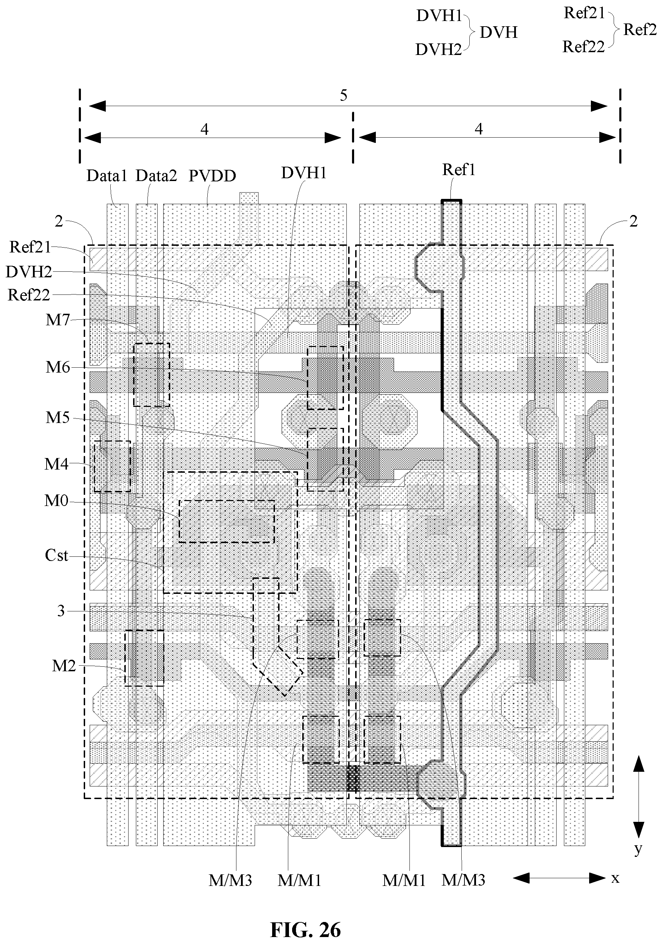

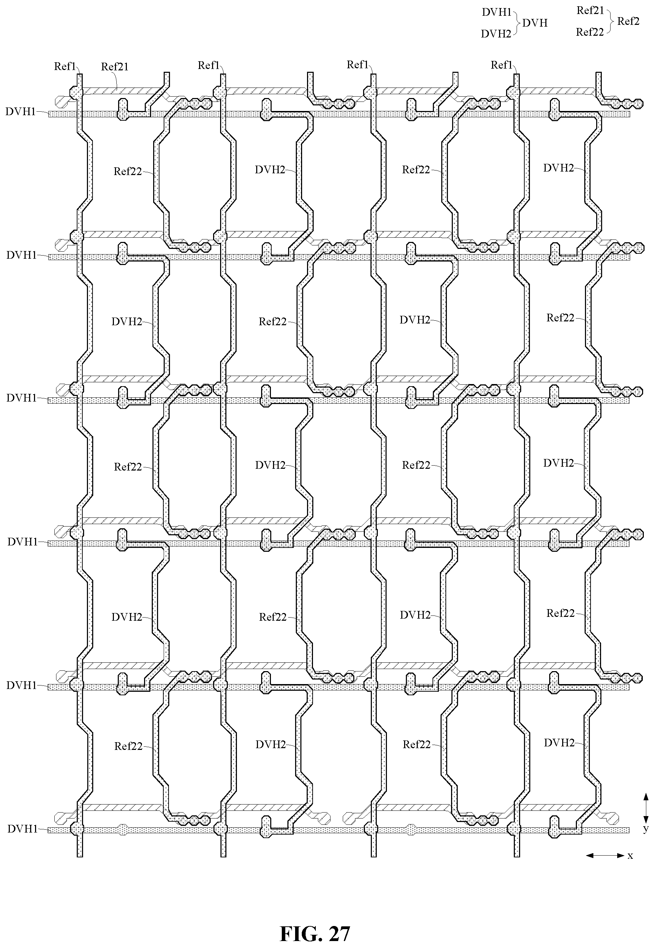

In a feasible embodiment, with reference to FIG. 2, as shown in FIG. 25 to FIG. 27, FIG. 25 is a schematic structural diagram of a further display panel according to an embodiment of the present disclosure, FIG. 26 is a schematic diagram of a further film layer structure of a display panel according to an embodiment of the present disclosure, and FIG. 27 is a schematic diagram of a further film layer structure of a display panel according to an embodiment of the present disclosure. The first transistor M includes a gate reset transistor M1. The gate reset transistor M1 is electrically connected between a first reset line Ref1 and the gate of the driving transistor M0.

One first circuit group 5 corresponds to one first reset line Ref1. The first reset line Ref1 extends along the second direction y and is disposed on the same layer as the connection line 3. The first electrodes of two adjacent gate reset transistors M1 in the first circuit group 5 in the first direction x are connected to the corresponding first reset line Ref1.

Since the first transistors M in the two circuit columns 4 in the first circuit group 5 are arranged adjacent to each other, even if only one first reset line Ref1 extending in the vertical direction is provided for these two circuit columns 4, the first reset line Ref1 can be conveniently connected to the first transistors M in the two circuit columns 4, which greatly reduces the number of first reset lines Ref1 required to be provided in the display panel and optimizes the layout design.

Moreover, since there are many wirings on the film layer where the data line Data and the power supply signal line PVDD are disposed, the first reset line Ref1 can be disposed on the same layer as the connection line 3, so that it does not occupy the routing space of the first wiring layer sd2. When designing the power supply signal line PVDD, there is no need to consider the influence of the first reset line Ref1 on the line width of the power supply signal line PVDD, so that the power supply signal line PVDD can be designed to be wider to better shield the connection line 3 and the first transistor M.

In a feasible embodiment, with reference to FIG. 2, and FIG. 25 to FIG. 27, the pixel circuit 2 further includes an anode reset transistor M6. The anode reset transistor M6 is electrically connected between the second reset line Ref2 and the light-emitting element 8. The second reset line Ref2 includes a first reset sub-line Ref21 and a second reset sub-line Ref22 that are electrically connected to each other. The first reset sub-line Ref21 extends along the first direction x, and the second reset sub-line Ref22 is connected between two adjacent first reset sub-lines Ref21.

The pixel circuit 2 further includes a bias transistor M7. The bias transistor M7 is electrically connected between a bias signal line DVH and the drive transistor M0. The bias signal line DVH includes a first bias sub-line DVH1 and a second bias sub-line DVH2. The first bias sub-line DVH1 extends along the first direction x, and the second bias sub-line DVH2 is connected between two adjacent first bias sub-lines DVH1.

The second reset sub-line Ref22 and the second bias sub-line DVH2 are disposed on the same layer. Along the first direction x, the second reset sub-line Ref22 and the second bias sub-line DVH2 are alternately arranged. Along the second direction y, the second reset sub-line Ref22 and the second bias sub-line DVH2 are alternately arranged.

In the above configuration, the second reset line Ref2 and the bias signal line DVH both adopt a horizontal-vertical double-line design, which can effectively reduce their respective loads.

Furthermore, in an embodiment of the present disclosure, the wirings of the second reset line Ref2 and the bias signal line DVH that extend in the vertical direction are further designed in a matched manner. The wirings of the second reset line Ref2 and the bias signal line DVH that extend in the vertical direction are disposed on the same layer and are alternately arranged in both the first direction x and the second direction y. That is, the wirings of the second reset line Ref2 and the bias signal line DVH that extend in the vertical direction are not a single wiring across the display area 11, but rather a structure including multiple wiring segments, which can reduce the overall space occupied by the vertical wirings of the two signal lines, thereby optimizing the wiring arrangement while lowering the load.

Furthermore, with reference to FIG. 2, and FIG. 25 to FIG. 27, the first transistor M includes the gate reset transistor M1. The gate reset transistor M1 is electrically connected between the first reset line Ref1 and the gate of the driving transistor M0. One first circuit group 5 is correspondingly provided with one first reset line Ref1. The first reset line Ref1 extends along the second direction y and is disposed on the same layer as the connection line 3. The first electrodes of two adjacent gate reset transistors M1 in the first circuit group 5 in the first direction x are connected to the corresponding first reset line Ref1.

The first reset line Ref1, the second reset sub-line Ref22 and the second bias sub-line DVH2 are disposed on the same layer. The first reset lines Ref1 are provided between two adjacent second reset sub-lines Ref22 in the first direction x and the second bias sub-line DVH2, thereby distributing a reasonable wiring method for the first reset line Ref1, the second reset line Ref2 and the bias signal line DVH, and optimizing the layout design.

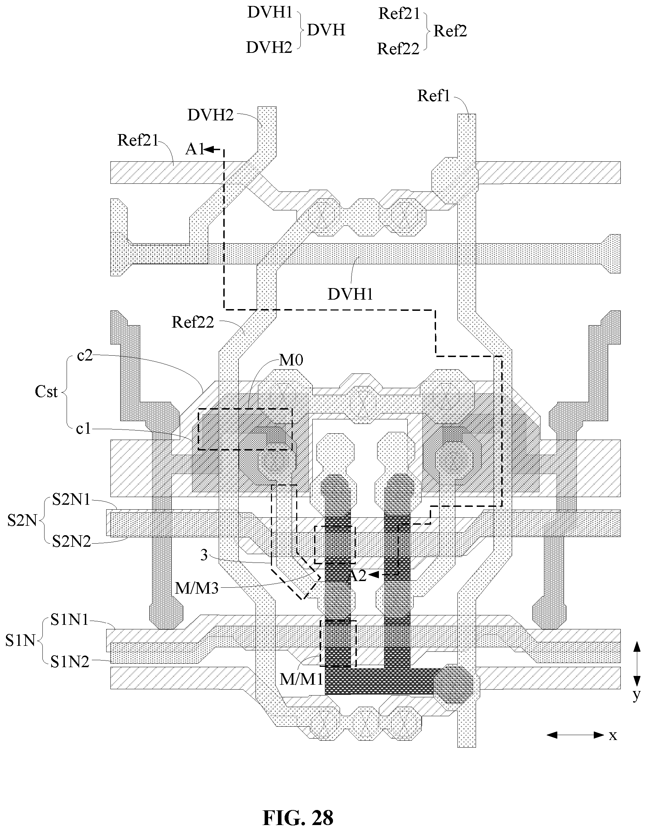

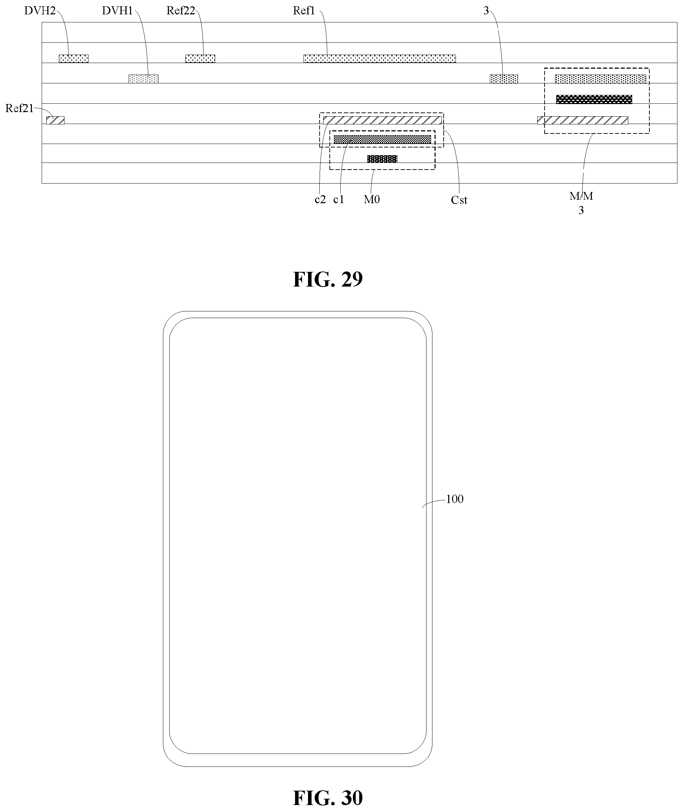

In a feasible embodiment, with reference to FIG. 2, and FIG. 25 to FIG. 27, as shown in FIG. 28 and FIG. 29, FIG. 28 is a schematic diagram of a further film layer structure of a display panel according to an embodiment of the present disclosure, and FIG. 29 is a cross-sectional view of FIG. 28 along A1-A2 direction. The pixel circuit 2 further includes a storage capacitor Cst. A first plate c1 of the storage capacitor Cst is multiplexed with the gate of the driving transistor M0.

The first reset sub-line Ref21 is disposed on the same layer as the second plate c2 of the storage capacitor Cst, the first bias sub-line DVH1 is disposed on the same layer as the top gate of the first transistor M, and the second reset sub-line Ref22 and the second bias sub-line DVH2 are disposed on the same layer as the connection line 3.

The metal layer where the second plate c2 of the storage capacitor Cst is disposed and the metal layer where the top gate of the first transistor M is disposed have relatively few wirings. By respectively providing the first reset sub-line Ref21 and the first bias sub-line DVH1 on these two metal layers, a reasonable design of the overall wiring can be achieved. Meanwhile, the second reset sub-line Ref22 and the second bias sub-line DVH2 are disposed on the same layer as the connection line 3, so that neither requires occupying an additional film layer, resulting in better wiring.

In a feasible implementation, with reference to FIG. 2 and FIG. 28, the pixel circuit 2 further includes the storage capacitor Cst. The first plate c1 of the storage capacitor Cst is reused with the gate of the driving transistor M0.

The first transistor M includes the gate reset transistor M1, and the gates of the gate reset transistor M1 are electrically connected to a first scanning line S1N. The gates of the gate reset transistor M1 may include a top gate and a bottom gate. The first scanning line S1N includes a first scanning sub-line S1N1 and a second scanning sub-line S1N2 that extend along the first direction x and are electrically connected to each other. The first scanning sub-line S1N1 is disposed on the same layer as the second plate c2 of the storage capacitor Cst. A portion of the second scanning sub-line S1N2 is reused as the top gate of the gate reset transistor M1. In the direction perpendicular to the plane of the substrate 1, the first scanning sub-line S1N1 overlaps the second scanning sub-line S1N2.

Meanwhile or alternatively, the first transistor M includes a threshold compensation transistor M3, and the gates of the threshold compensation transistor M3 are electrically connected to the second scanning line S2N. The gates of the threshold compensation transistor M3 may include a top gate and a bottom gate. The second scanning line S2N includes a third scanning sub-line S2N1 and a fourth scanning sub-line S2N2 that extend along the first direction x and are electrically connected to each other. The third scanning sub-line S2N1 is disposed on the same layer as the second plate c2 of the storage capacitor Cst. A portion of the fourth scanning sub-line S2N2 is reused as the top gate of the threshold compensation transistor M3. In the direction perpendicular to the plane of the substrate 1, the third scanning sub-line S2N1 overlaps the fourth scanning sub-line S2N2.

In the above configuration, both the first scanning line S1N and the second scanning line S2N are provided with dual-layer wirings, which help to reduce the load of the two scanning lines and reduce the voltage drop.

The following takes the circuit structure shown in FIG. 2 as an example to specifically describe a structure of a pixel circuit 2 according to an embodiment of the present disclosure.

The pixel circuit 2 includes: a driving transistor M0, a gate reset transistor M1, a data writing transistor M2, a threshold compensation transistor M3, a first light-emitting control transistor M4, a second light-emitting control transistor M5, an anode reset transistor M6, a bias transistor M7, and a storage capacitor Cst.

The gate of the driving transistor M0 is electrically connected to the first node N1, the first electrode of the driving transistor M0 is electrically connected to the second node N2, and the second electrode of the driving transistor M0 is electrically connected to the third node N3.

The first electrode of the gate reset transistor M1 is electrically connected to the first scanning line S1N, the second electrode of the gate reset transistor M1 is electrically connected to the first reset line Ref1, and the second electrode of the gate reset transistor M1 is electrically connected to the first node N1.

The gate of the data writing transistor M2 is electrically connected to the third scanning line S1P, the first electrode of the data writing transistor M2 is electrically connected to the data line Data, and the second electrode of the data writing transistor M2 is electrically connected to the second node N2.

The gate of the threshold compensation transistor M3 is electrically connected to the second scanning line S2N, the first electrode of the threshold compensation transistor M3 is electrically connected to the third node N3, and the second electrode of the threshold compensation transistor M3 is electrically connected to the first node N1.

The gate of the first light-emitting control transistor M4 is electrically connected to the light-emitting control signal line Emit, the first electrode of the first light-emitting control transistor M4 is electrically connected to the power supply signal line PVDD, and the second electrode of the first light-emitting control transistor M4 is electrically connected to the second node N2.

The gate of the second light-emitting control transistor M5 is electrically connected to the light-emitting control signal line Emit, the first electrode of the second light-emitting control transistor M5 is electrically connected to the third node N3, and the second electrode of the second light-emitting control transistor M5 is electrically connected to the light-emitting element 8.

The gate of the anode reset transistor M6 is electrically connected to the fourth scanning line S2P, the first electrode is of the anode reset transistor M6 electrically connected to the second reset line Ref2, and the second electrode of the anode reset transistor M6 is electrically connected to the light-emitting element 8.

The gate of the bias transistor M7 is electrically connected to the fourth scanning line S2P, the first electrode of the bias transistor M7 is electrically connected to the bias signal line DVH, and the second electrode of the bias transistor M7 is electrically connected to the second node N2.

The first plate c1 of the storage capacitor Cst is electrically connected to the first node N1, and the second plate c2 of the storage capacitor Cst is electrically connected to the power supply signal line PVDD.

Based on the same inventive concept, an embodiment of the present disclosure further provides a display apparatus, as shown in FIG. 30, FIG. 30 is a schematic structural diagram of a display apparatus according to an embodiment of the present disclosure. The display apparatus includes the above display panel 100. The specific structure of the display panel 100 has been described in detail in the above embodiments and will not be repeated here. The display apparatus shown in FIG. 30 is merely for illustration, and the display apparatus may be any electronic device with a display function, such as a mobile phone, tablet computer, laptop computer, e-reader, or television.

The above description is only preferred embodiments of the present disclosure and is not intended to limit the present disclosure. Any modifications, equivalent substitutions, improvements, etc. made within the spirit and principles of the present disclosure should fall within the protection scope of the present disclosure.

It should be noted that the above embodiments are only used to illustrate the technical solutions of the present disclosure, rather than to limit it. Although the present disclosure has been described in detail with reference to the above embodiments, those skilled in the art should understand that they can still modify the technical solutions described in the above embodiments, or replace some or all of the technical features therein with equivalents. However, these modifications or replacements do not cause the essence of the corresponding technical solutions to deviate from the scope of the technical solutions of the embodiments of the present disclosure.

## Claims

1. A display panel, comprising:
a substrate;
a pixel circuit comprising a driving transistor and at least one first transistor, wherein an active layer of the at least one first transistor comprises a metal oxide semiconductor material, and a gate of the driving transistor is electrically connected to one first transistor of the at least one first transistor through a connection line;
a plurality of circuit columns arranged along a first direction, wherein each circuit column of the plurality of circuit columns comprises pixel circuits arranged along a second direction, and the first direction intersects the second direction;
a plurality of first circuit groups arranged along the first direction, wherein each first circuit group of the plurality of first circuit groups comprises two circuit columns that are adjacent to each other, and in the first circuit group, the first transistors of two pixel circuits that are adjacent to each other in the first direction are arranged adjacent to each other;
data lines comprising a first data line and a second data line, wherein one of the first data line and the second data line is electrically connected to an odd-numbered pixel circuit of the pixel circuits in the circuit column, and the other one of the first data line and the second data line is electrically connected to an even-numbered pixel circuit of the pixel circuits in the circuit column; and
power supply signal lines electrically connected to the circuit columns;
wherein, for the first data line, the second data line, and a power supply signal line of the power supply signal lines that are connected to one circuit column of the circuit columns, the first data line and the second data line are disposed on one side of the driving transistor in the circuit column away from the first transistor, one power supply signal line of the power supply signal lines is disposed on a side of the first data line and the second data line that is adjacent to the first transistor in the circuit column, and in a direction perpendicular to a plane of the substrate, the power supply signal line overlaps the connection line and the active layer of the first transistor.

2. The display panel according to claim 1, wherein
the power supply signal line comprises a first line segment and a second line segment that are alternately arranged and sequentially connected in the second direction, and in the direction perpendicular to the plane of the substrate, the second line segment overlaps the connection line and the active layer of the first transistor; and
in two power supply signal lines connected to the first circuit group, second line segments of the two power supply signal lines are connected to each other.

3. The display panel according to claim 1, further comprising:
a plurality of light-emitting elements, wherein the plurality of light-emitting elements comprise a green light-emitting element; and
wherein in the direction perpendicular to the plane of the substrate, the green light-emitting element overlaps two power signal lines connected to the first circuit group.

4. The display panel according to claim 3, wherein
the power supply signal line comprises a first line segment and a second line segment that are alternately arranged and sequentially connected in the second direction;
a width of the second line segment is larger than a width of the first line segment in the first direction; and
and in a direction perpendicular to the plane of the substrate, the green light-emitting element overlaps the second line segment.

5. The display panel according to claim 3, wherein
the plurality of light-emitting elements further comprise a red light-emitting element and a blue light-emitting element;
the display panel further comprises a first light-emitting element group and a second light-emitting element group that are alternately arranged along the first direction, the first light-emitting element group comprises the red light-emitting element and the blue light-emitting element that are alternately arranged along the second direction, and the second light-emitting element group comprises the green light-emitting elements arranged along the second direction; and
in the direction perpendicular to the plane of the substrate, the second light-emitting element group overlaps the two power supply signal lines connected to the first circuit group, and the first light-emitting element group overlaps four adjacent data lines among which the driving transistor is not interposed.

6. The display panel according to claim 1, further comprising:
a display area and a first non-display area, wherein the display area comprises a first display area and a second display area, the first display area is located on at least one side of the second display area in the first direction, the first non-display area comprises a plurality of data connection wirings, and the plurality of data connection wirings are electrically connected to the data lines; and
the data lines in the first display area are electrically connected to the plurality of data connection wirings through data leads, a data lead of the data leads comprise a first data lead and a second data lead, the first data lead extends along the first direction, and the second data lead extends along the second direction.

7. The display panel according to claim 6, further comprising:
a source-drain layer, a first wiring layer, and a second wiring layer,
wherein the first wiring layer is disposed on a side of the source-drain layer away from the substrate, and the second wiring layer is disposed on a side of the first wiring layer away from the substrate; and
wherein the connection lines are disposed on the source-drain layer, the data lines and the power supply signal lines are disposed on the first wiring layer, and the data leads are disposed on the second wiring layer.

8. The display panel according to claim 6, wherein
the data line is electrically connected to the first data lead through a first via;
four adjacent data lines among which the driving transistor is not interposed form a data line group, and four first vias connected to the data line group form a via group; and
in a direction from the first display area toward the second display area, distances between a plurality of via groups and a first edge decrease, distances between the first vias in a single via group and the first edge increase, wherein the first edge is an outer edge of the display panel extending along the first direction.

9. The display panel according to claim 6, wherein
the second data lead comprises a first lead, and in the direction perpendicular to the plane of the substrate, the first lead overlaps the data line.

10. The display panel according to claim 9, wherein
at most two data lines among four data lines connected to two adjacent circuit columns overlap the first lead.

11. The display panel according to claim 9, further comprising:
a plurality of demux circuits and 4m clock lines, wherein each demux circuit of the plurality of demux circuits comprises 4m gating switches, where m is a positive integer greater than or equal to 1;
in the demux circuit, control ends of the 4m gating switches are electrically connected to the 4m clock lines, and output ends of the 4m gating switches are electrically connected to a source signal line, output ends of 2m gating switches of the 4m gating switches are coupled to 2m first data lines, and output ends of the other 2m second gating switches of the 4m gating switches are coupled to 2m second data lines; and
for the first lead and the data line overlapping the first lead, the gating switch coupled to the first lead and the gating switch coupled to the data line are electrically connected to a same clock line.

12. The display panel according to claim 6, wherein
the second data lead comprises a second lead, and the second lead is disposed between adjacent data lines between which the driving transistor is not interposed.

13. The display panel according to claim 12, wherein
the second lead is disposed between the first data line and the second data line that are connected to a same circuit column.

14. The display panel according to claim 12, further comprising:
a plurality of demux circuits and 4m clock lines, wherein each demux circuit of the plurality of demux circuits comprises 4m gating switches, where m is a positive integer greater than or equal to 1;
in the demux circuit, control ends of the 4m gating switches are electrically connected to the 4m clock lines, and output ends of the 4m gating switches are electrically connected to a source signal line, output ends of 2m gating switches of the 4m gating switches are coupled to 2m first data lines, and output ends of the other 2m second gating switches of the 4m gating switches are coupled to 2m second data lines; and
for the second lead and one data line of the data lines adjacent to the second lead, the gating switch coupled to the second lead and the gating switch coupled to the data line adjacent to the second lead are electrically connected to a same clock line.

15. The display panel according to claim 6, wherein
four adjacent data lines among which the driving transistor is not interposed form a data line group; and
the second data lead comprises a third lead, and the third lead is disposed on at least one side of the data line group.

16. The display panel according to claim 15, further comprising:
a plurality of demux circuits and 4m clock lines, wherein each demux circuit of the plurality of demux circuits comprises 4m gating switches, where m is a positive integer greater than or equal to 1;
in the demux circuit, control ends of the 4m gating switches are electrically connected to the 4m clock lines, and output ends of the 4m gating switches are electrically connected to a source signal line, output ends of 2m gating switches of the 4m gating switches are coupled to 2m first data lines, and output ends of the other 2m second gating switches of the 4m gating switches are coupled to 2m second data lines;
the circuit column comprises a first circuit column and a second circuit column, the first data line connected to the first circuit column is disposed on one side of the second data line adjacent to the driving transistor, and the second data line connected to the second circuit column is disposed on one side of the first data line adjacent to the driving transistor; and
for the third lead and the data line adjacent to the third lead, the gating switch coupled to the third lead and the gating switch coupled to the data line adjacent to the third lead are electrically connected to a same clock line.

17. The display panel according to claim 6, further comprising:
a light-emitting element, wherein the light-emitting element comprises an anode;
a first wiring and a second wiring, wherein the first wiring is disposed on a same layer and extends in a same direction as the first data lead, the second wiring is disposed on a same layer and extends in a same direction as the second data lead, and a break is provided between the first wiring and the first data lead, and between the second wiring and the second data lead; and
a shielding portion, wherein the shielding portion and the anode are disposed on a same layer and are connected to each other, and in the direction perpendicular to the plane of the substrate, the shielding portion overlaps the break.

18. The display panel according to claim 1, wherein
the power supply signal line comprises a first line segment and a second line segment that are alternately arranged and sequentially connected in the second direction, in the direction perpendicular to the plane of the substrate, the second line segment overlaps the connection line and the active layer of the first transistor, and a width of the second line segment in the first direction is larger than a width of the first line segment in the first direction; and
for two power supply signal lines connected to the first circuit group, a first auxiliary power supply line is connected between the first line segments of the two power supply signal lines, and/or a second auxiliary power supply line is disposed in parallel with the first line segment.

19. The display panel according to claim 1, wherein
the first transistor comprises a gate reset transistor, and the gate reset transistor is electrically connected between a first reset line and the gate of the driving transistor; and
one first circuit group is provided with one corresponding first reset line, the first reset line extends along the second direction and is disposed on a same layer as the connection line, and first electrodes of two adjacent gate reset transistors in the first circuit group in the first direction are connected to the corresponding first reset line.

20. The display panel according to claim 1, wherein
the pixel circuit further comprises an anode reset transistor, the anode reset transistor is electrically connected between a second reset line and a light-emitting element, the second reset line comprises a first reset sub-line and a second reset sub-line that are electrically connected to each other, the first reset sub-line extends along the first direction, and the second reset sub-line is connected between two adjacent first reset sub-lines;
the pixel circuit further comprises a bias transistor, the bias transistor is electrically connected between a bias signal line and the drive transistor, the bias signal line comprises a first bias sub-line and a second bias sub-line, the first bias sub-line extends along the first direction, and the second bias sub-line is connected between two adjacent first bias sub-lines; and
the second reset sub-line and the second bias sub-line are disposed on a same layer; along the first direction, the second reset sub-line and the second bias sub-line are alternately arranged; and along the second direction, the second reset sub-line and the second bias sub-line are alternately arranged.

21. The display panel according to claim 20, wherein
the first transistor comprises a gate reset transistor, the gate reset transistor is electrically connected between a first reset line and the gate of the driving transistor, one first circuit group is provided with one corresponding first reset line, the first reset line extends along the second direction and is disposed on a same layer as the connection line, and first electrodes of two adjacent gate reset transistors in the first circuit group in the first direction are connected to the corresponding first reset line; and
the first reset line, the second reset sub-line and the second bias sub-line are disposed on a same layer, the first reset line is provided between two adjacent second reset sub-lines in the first direction and second bias sub-lines.

22. The display panel according to claim 20, wherein
the pixel circuit further comprises a storage capacitor, and a first plate of the storage capacitor is reused as the gate of the driving transistor; and
the first reset sub-line is disposed on a same layer as a second plate of the storage capacitor, the first bias sub-line is disposed on a same layer as a top gate of the first transistor, and the second reset sub-line and the second bias sub-line are disposed on a same layer as the connection line.

23. The display panel according to claim 1, wherein
the pixel circuit further comprises a storage capacitor, and a first plate of the storage capacitor is reused as the gate of the driving transistor;
the first transistor comprises a gate reset transistor, and a gate of the gate reset transistor is electrically connected to a first scanning line, the first scanning line comprises a first scanning sub-line and a second scanning sub-line that extend along the first direction and are electrically connected to each other, the first scanning sub-line is disposed on a same layer as a second plate of the storage capacitor, a portion of the second scanning sub-line is reused as a top gate of the gate reset transistor, and in the direction perpendicular to the plane of the substrate, the first scanning sub-line overlaps the second scanning sub-line; and/or
the first transistor comprises a threshold compensation transistor, and a gate of the threshold compensation transistor is electrically connected to a second scanning line, the second scanning line comprises a third scanning sub-line and a fourth scanning sub-line that extend along the first direction and are electrically connected to each other, the third scanning sub-line is disposed on a same layer as a second plate of the storage capacitor, a portion of the fourth scanning sub-line is reused as a top gate of the threshold compensation transistor, and in the direction perpendicular to the plane of the substrate, the third scanning sub-line overlaps the fourth scanning sub-line.

24. A display apparatus, comprising the display panel according to any one of claims 1 to 23.
